# EUROPÄISCHE PATENTSCHRIFT

(11) **EP 1 741 148 B1**
(45) Veröffentlichungstag und Bekanntmachung des Hinweises auf die Patenterteilung: **03.06.2009**
(21) Anmeldenummer: 05741399.9
(22) Anmeldetag: 26.04.2005
(51) Int. Cl.: H01L 51/30, C08G 61/12, C08L 65/00, C09K 11/06

(54) **ELEKTROLUMINESZIERENDE POLYMERE ENTHALTEND PLANARE ARYLAMIN-EINHEITEN, DEREN DARSTELLUNG UND VERWENDUNG**
ELECTROLUMINESCENT POLYMERS COMPRISING PLANAR ARYLAMINE UNITS THE PREPARATION AND USE THEREOF
POLYMERES ELECTROLUMINESCENTES CONTENANT DES UNITES ARYLAMINE PLANAIRES, LEUR PREPARATION ET LEUR UTILISATION

(30) Priorität: 26.04.2004 DE 102004020299
(43) Veröffentlichungstag der Anmeldung: 10.01.2007
(73) Patentinhaber: Merck Patent GmbH, 64293 Darmstadt (DE)
(72) Erfinder: PARHAM, Amir, 65929 Frankfurt (DE); HEUN, Susanne, 65812 Bad Soden (DE); LUDEMANN, Aurélie, 60322 Frankfurt (DE); BÜSING, Arne, 65929 Frankfurt (DE); PAN, Junyou, 60435 Frankfurt (DE); BECKER, Heinrich, 65719 Hofheim (DE)
(86) Internationale Anmeldenummer: PCT/EP2005/004447
(87) Internationale Veröffentlichungsnummer: WO 2005/104263

(56) Entgegenhaltungen:
- EP-A- 0 953 624
- EP-A- 1 400 578
- WO-A-02/077060
- WO-A-20/04037887
- US-A- 6 066 712

## Beschreibung

Seit ca. 13 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in WO 90/13148 offenbart sind. Seit kurzem ist ein erstes, wenn auch einfaches Produkt (eine kleine Anzeige in einem Rasierapparat der Fa. PHILIPS N.V.) auf dem Markt erhältlich. Allerdings sind immer noch deutliche Verbesserungen der verwendeten Materialien nötig, um diese Displays zu einer echten Konkurrenz zu den derzeit marktbeherrschenden Flüssigkristallanzeigen (LCD) zu machen.

Dabei ist es für die Erzeugung aller drei Emissionsfarben nötig, bestimmte Comonomere in die entsprechenden Polymere einzupolymerisieren (vgl. z. B. WO 00/46321, WO 03/020790 und WO 02/077060). So ist dann in der Regel, ausgehend von einem blau emittierenden Grundpolymer ("backbone"), die Erzeugung der beiden anderen Primärfarben Rot und Grün möglich.

Des Weiteren wurde berichtet, dass das Einfügen bestimmter Arylamino-Gruppierungen eine Verbesserung der Eigenschaften ergibt:
- WO 99/54385 beschreibt Polyfluorene, deren Effizienz und Einsatzspannung verbessert werden kann, indem Derivate von Triphenylamin, Tetraphenyl-p-diaminobenzol oder Tetraphenyl-4,4'-diaminobiphenyl in die Hauptkette der entsprechenden Polymere mit einpolymerisiert werden.
- WO 01/49769 beschreibt Polymere, welche Triarylamino-Gruppen enthalten, bei welchen mindestens eine Arylgruppe eine Heteroarylgruppe darstellt. Besondere Vorteile dieser Polymere werden nicht beschrieben.
- In WO 04/037887 werden Triarylamin-Einheiten beschrieben, die kondensierte Aryl-Substituenten, wie beispielsweise Naphthyl-Einheiten, enthalten. Diese eignen sich besonders gut für Passiv-Matrix-Anwendungen.
- In WO 04/106409 werden Tris- und Tetrakis-Triarylamine als Lochleiter und Emitter in konjugierten Polymeren beschrieben.
- In WO 05/017065 werden statt Triarylamin-Derivaten Triarylphosphin-Derivate als Lochleiter in konjugierten Polymeren vorgeschlagen.

Die Polymere gemäß dem Stand der Technik zeigen zum Teil schon gute Eigenschaften in der Anwendung in PLEDs. Trotz der bereits erzielten Fortschritte entsprechen sie allerdings noch nicht den Anforderungen, die an sie für hochwertige Anwendungen gestellt werden Insbesondere ist die Lebensdauer der grün und vor allem der blau emittierenden Polymere für viele Anwendungen noch nicht ausreichend.

Es wurde nun überraschend gefunden, dass konjugierte oder teilkonjugierte Polymere, die bestimmte planare Bis(triarylamin)-Einheiten enthalten, sehr gute und den Stand der Technik übertreffende Eigenschaften aufweisen. Dies bezieht sich insbesondere auf die Lebensdauer, aber auch auf die Strom-Spannungskurven und die Effizienz der Polymere. Diese Polymere und deren Verwendung in PLEDs sind daher Gegenstand der vorliegenden Erfindung.
Tetraphenyl-p-diaminobenzol, dessen zentrale Einheit (Phenylen) auch planar aufgebaut ist, ist hierfür ungeeignet, da es in Kombination mit einigen Monomeren zu starken Farbverschiebungen führt.

In US 6066712 werden alternierende Lochinjektionspolymere beschrieben, bestehend aus Divinylarylen-Einheiten und aromatischen Diaminen, die über eine polykondensierte, cyclische Gruppe, wie beispielsweise Fluoren oder Dihydrophenanthren, verbrückt sind. Diese Polymere eignen sich jedoch offensichtlich nicht für hochwertige OLED-Anwendungen, da hiermit in OLEDs sehr schlechte Lebensdauern in der Größenordnung von 200 h bei einer sehr geringen Stromdichte (und somit sehr geringer Helligkeit) von nur 1 mA/cm² erreicht werden

Gegenstand der Erfindung sind konjugierte oder teilkonjugierte Polymere, enthaltend mindestens 0.1 mol%, bevorzugt mindestens 1 mol%, besonders bevorzugt mindestens 5 mol%, ganz besonders bevorzugt mindestens 7 mol% Einheiten gemäß Formel (1), 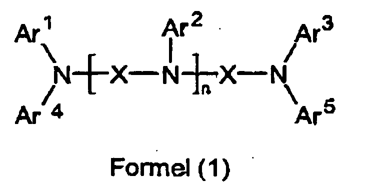 wobei die verwendeten Symbole und Indizes folgende Bedeutung besitzen:
- X: ist bei jedem Auftreten gleich oder verschieden ein bivalentes planares konjugiertes System mit 6 bis 40 C-Atomen, das mindestens 2 Arylengruppen enthält und das mit R¹ substituiert sein kann;
- Ar¹, Ar², Ar³, Ar⁴, Ar⁵: ist bei jedem Auftreten gleich oder verschieden ein aromatisches Ringsystem mit 6 bis 40 C-Atomen, das mit einem oder mehreren Resten R¹ substituiert sein kann, oder ein heteroaromatisches Ringsystem mit 2 bis 40 C-Atomen, das mit einem oder mehreren Resten R¹ substituiert sein kann, mit der Maßgabe, dass keine der Gruppen Ar¹ bis Ar⁵ ein kondensiertes Ringsystem darstellt, wenn diese Gruppe nicht eine direkte Bindung zur Polymerkette aufweist;
- R¹: ist bei jedem Auftreten gleich oder verschieden H, F, Cl, Br, I, CN, NO₂, OH, N(R¹)₂, Si(R²)₃, B(R²)₂, eine geradkettige, verzweigte oder cyclische Alkyl-, Alkoxy- oder Thioalkoxygruppe mit 1 bis 40 C-Atomen, in der auch ein oder mehrere nicht benachbarte C-Atome durch -CR²=CR²-, -C≡C-,
- NR²-, -O-, -S-, -CO-O- oder -O-CO-O- ersetzt sein können, wobei auch ein oder mehrere H-Atome durch Fluor ersetzt sein können, eine Aryl-, Heteroaryl-, Aryloxy- oder Heteroaryloxygruppe mit 2 bis 40 C-Atomen, bei der auch ein oder mehrere C-Atome durch O, S oder N ersetzt sein können und welche auch durch einen oder mehrere nicht-aromatische
Reste R¹ substituiert sein kamin; dabei können auch zwei oder mehrere der Reste R¹ miteinander ein aliphatisches oder aromatisches, mono-oder polycyclisches Ringsystem bilden;
- R²: ist bei jedem Auftreten gleich oder verschieden H oder ein aliphatischer oder aromatischer Kohlenwasserstoffrest mit 1 bis 20 C-Atomen;
- n: ist bei jedem Auftreten gleich oder verschieden 0, 1 oder 2;
die Verknüpfung der Einheiten gemäß Formel (1) mit dem Polymer erfolgt über eine oder zwei der Einheiten Ar¹ bis Ar⁵;
ausgenommen Polymere gemäß Formel (2), 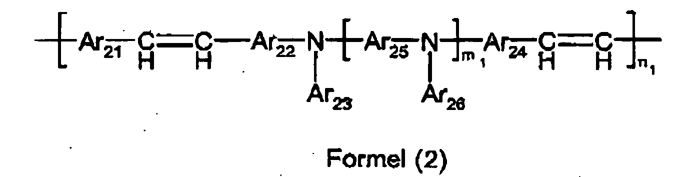 worin gilt: Ar₂₁, Ar₂₂, Ar₂₄ sind jeweils eine Arylengruppe, die einen Substituenten tragen kann; Ar₂₅ ist eine Arylengruppe oder eine bivalente polykondensierte Ringgruppe, die einen Substituenten tragen kann; Ar₂₃ und Ar₂₆ sind jeweils eine Alkylgruppe, eine Aralkylgruppe oder eine Arylgruppe, die einen Substituenten tragen kann; m₁ ist 0, 1, 2 oder 3; n₁ ist eine natürliche Zahl;
ausgenommen weiterhin konjugierte Polymere enthaltend mindestens 1 mol%, Einheiten gemäß Formel (I), 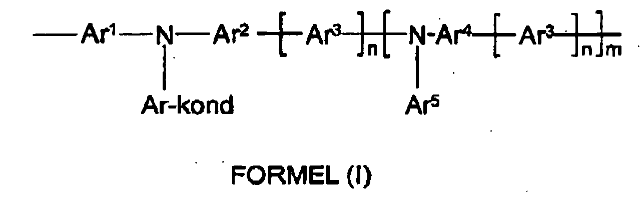 wobei die Symbole und Indizes folgende Bedeutung besitzen:
- Ar¹, Ar³: sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
- Ar², Ar⁴: sind bei jedem Auftreten gleich oder verschieden Ar¹, Ar³ bzw. einer substituierten bzw. unsubstituierten Stilbenylen- bzw. Tolanyleneinheit;
- Ar-kond: ist bei jedem Auftreten gleich oder verschieden einem aromatischen oder heteroaromatischen Ringsystem, welches mindestens 9, höchstens aber 40 Atome (C- oder Heteroatome) im konjugierten System besitzt, welches substituiert oder auch unsubstituiert sein kann und welches aus mindestens zwei kondensierten Ringen besteht; die möglichen Substituenten R1 können dabei potentiell an jeder freien Position sitzen;
- Ar⁵: ist gleich oder verschieden bei jedem Auftreten entweder einem aromatischen oder heteroaromatischen Ringsystem mit 2 bis 40 C-Atomen, welches substituiert oder auch unsubstituiert sein kann oder Ar-kond; die möglichen Substituenten R1 können dabei potentiell an jeder freien Position sitzen;
- m, n: sind gleich oder verschieden bei jedem Auftreten 0, 1 oder 2;
- R1: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R2, d, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S

- oder N: ersetzt sein können, welche auch durch ein oder mehrere nicht-aromatische Reste R1 substituiert sein können, oder Cl, F, CN, N(R2)₂, B(R2)₂, wobei auch zwei oder mehrere Reste R1 miteinander ein Ringsystem bilden können;
- R2: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können,
mit der Maßgabe, das die Einheiten gemäß den Strukturen (1) bis (3) 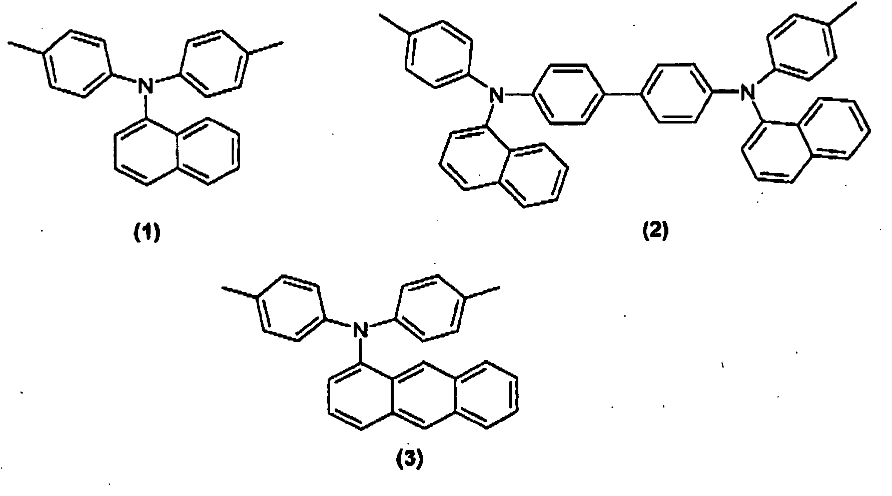 ausgenommen sind, wenn das konjugierte Polymer Metallkomplexe enthält, welche einen Transfer von Singulett-Excitonen zu Triplett-Excitonen ermöglichen.

Bevorzugt sind die erfindungsgemäßen Polymere konjugiert.

Die Einheiten gemäß Formel (1) können in die Hauptkette oder in die Seitenkette des Polymers gebunden sein, bevorzugt in die Hauptkette. Wenn die Einheiten gemäß Formel (1) in die Hauptkette des Polymers gebunden sind, sind zwei der Gruppen Ar¹ bis Ar⁵ bivalente Gruppen mit Anknüpfung an die Polymerkette, während die anderen monovalente Gruppen sind. Wenn die Einheiten gemäß Formel (1) in die Seitenkette des Polymers gebunden sind, ist eine der Gruppen Ar¹ bis Ar⁵ eine bivalente Gruppe mit Anknüpfung an die Polymerkette, während die anderen monovalente Gruppen sind.

Auch wenn dies aus der Beschreibung hervorgeht, sei hier nochmals explizit darauf verwiesen, dass die Struktureinheiten gemäß Formel (1) unsymmetrisch substituiert sein können, d. h. dass in einer Einheit unterschiedliche Gruppen X und/oder unterschiedliche Gruppen Ar¹ bis Ar⁵ bzw. unterschiedliche Substituenten R¹ und R² vorhanden sein können, bzw. diese auch an unterschiedlichen Positionen gebunden sein können.

Unter einem "bivalenten planaren konjugierten System" im Sinne dieser Erfindung, wie es durch das Symbol X beschrieben wird, soll ein bivalentes konjugiertes System verstanden werden, das mindestens zwei Arylengruppen enthält, die miteinander und mit den Stickstoffatomen in Konjugation stehen und deren Diederwinkel kleiner als 35° ist, bevorzugt kleiner als 30°, besonders bevorzugt kleiner als 25°. Da der gemessene bzw. berechnete Diederwinkel immer von der Bestimmungsmethode abhängt, soll im Sinne dieser Erfindung der Diederwinkel durch quantenchemische Rechnung erfolgen. Dafür wird die Geometrie mittels "Bemy"-Optimierung (H. B. Schlegel et al., J. Comp. Chem. 1996, 17, 49) mit der semiempirischen Methode AM1 (z. B. M. J. S. Dewar et al., J. Am. Chem. Soc. 1985, 107, 3902) in internen Koordinaten ermittelt. Die Berechnung der Energien und Orbitale erfolgt dann durch Dichtefunktionaltheorie mit dem Hybrid-Funktionalen B3PW91 (J. P. Perdew, Phys. Rev. B 1996, 54, 16533) und dem "Split-Valence" Basissatz 6-31G(d) (J. A. Pople et al., J. Phys. Chem. 1971, 54, 724), wobei alle Rechnungen mit dem Gaussian 98 Programmpaket (J. A. Pople, Gaussian, Inc., Pittsburgh PA, 2001) durchgeführt werden.
Dabei muss das planare konjugierte System nicht zwangsläufig nur konjugierte Gruppen enthalten, sondern kann auch beispielsweise aliphatische Brücken enthalten, die die Arylengruppen überbrücken und damit die Planarität des Systems herbeiführen. Ebenso kann das System substituiert sein, wobei auch die Substituenten selbst wiederum ein oder mehrere Ringsysteme ausbilden können. Bevorzugt sind steife planare konjugierte Systeme, die nicht durch Rotation um eine Einfachbindung von der Planarität abweichen können.
Beispiele für planare konjugierte Systeme sind Fluoren (Diederwinkel im Diamin 0.1°), trans-Indenofluoren (Diederwinkel im Diamin 0.5°), Dihydrophenanthren (Diederwinkel im Diamin 20.2°) und Tolan (Diederwinkel im Diamin 0.7°), wobei das Tolan kein steifes System darstellt. Im Gegensatz dazu ist der Diederwinkel im Biphenyl, wie es gemäß dem Stand der Technik verwendet wird, 42°; Biphenyl stellt somit kein planares System dar.

Unter einer Arylengruppe im Sinne dieser Anmeldung wird eine einfache oder kondensierte bivalente aromatische oder heteroaromatische Gruppe, wie z. B. Phenylen, Naphthylen, etc., verstanden, wohingegen beispielsweise ein Biphenyl-System oder ein Fluoren-System nicht als eine einfache Arylengruppe verstanden werden soll, da hier zwei Phenyleneinheiten über eine Einfachbindung (und im Fluoren noch über eine zusätzliche nicht-konjugierte Brücke) verbunden sind. Dabei enthalten die aromatischen Gruppen mindestens 6 C-Atome und die heteroaromatischen Gruppen mindestens 2 C-Atome.

Unter einem aromatischen bzw. heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nicht-aromatische Einheit (< 10 % der von H verschiedenen Atome, bevorzugt < 5 % der von H verschiedenen Atome), wie beispielsweise sp³-hybridisierter C, O, N, etc., unterbrochen sein können. So sollen also beispielsweise auch Systeme wie 9,9'-Spirobifluoren, 9,9-Diarylfluoren, Triarylamin, etc. als aromatische Ringsysteme im Sinne dieser Erfindung verstanden werden. Dabei enthalten die aromatischen Ringsysteme mindestens 6 C-Atome und die heteroaromatischen Ringsysteme mindestens 2 C-Atome.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 2 bis 40 C-Atomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Konjugierte Polymere im Sinne dieser Erfindung sind Polymere, die in der Hauptkette hauptsächlich sp²-hybridisierte (bzw. gegebenenfalls auch sphybridisierte) Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette. Hauptsächlich meint, dass natürlich (unwillkürlich) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette beispielsweise Arylamin-, Arylphosphin- oder Arylarsineinheiten, wie zum Beispiel Einheiten gemäß Formel (1), und/oder bestimmte Heterocyclen (d. h. Konjugation über N-, O-, P- oder S-Atome) und/oder metallorganische Komplexe (d. h. Konjugation über das Metallatom) befinden. Hingegen würden Einheiten wie beispielsweise einfache Alkylbrücken, (Thio)Ether-, Ester-, Amid- oder Imidverknüpfungen eindeutig als nicht-konjugierte Segmente definiert. Unter einem teilkonjugierten Polymer soll ein Polymer verstanden werden, in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält.

Der Einbau der Einheiten gemäß Formel (1) in das konjugierte Polymer kann über beliebige Positionen der aromatischen Einheiten Ar¹ bis Ar⁵ erfolgen. Bevorzugt erfolgt der Einbau in die Seitenkette über die Gruppe Ar¹ und der Einbau in die Hauptkette über die Gruppen Ar¹ und Ar³. Bevorzugt ist dabei, wenn die Verknüpfung so erfolgt, dass eine gerade Anzahl C-Atome (bzw. entsprechender Heteroatome, also N, O und/oder S) zwischen der Verknüpfung mit dem Polymer und dem Stickstoffatom liegt. Besonders bevorzugt ist die Anzahl der C-Atome (bzw. entsprechender Heteroatome) ein Vielfaches von vier.

Die erfindungsgemäßen Polymere enthalten neben Einheiten gemäß Formel (1) bevorzugt noch weitere Strukturelemente und sind somit als Copolymere zu bezeichnen. Hier sei vor allem auch auf die relativ umfangreichen Auflistungen in WO 02/077060, in WO 05/014689 und die darin aufgeführten Zitate verwiesen.
Diese weiteren Struktureinheiten können beispielsweise aus den im Folgenden beschriebenen Klassen stammen:
Gruppe 1: Einheiten, welche das Polymer-Grundgerüst darstellen:
   Einheiten dieser Gruppe sind solche, die aromatische, carbocyclische Strukturen mit 6 bis 40 C-Atomen beinhalten, die substituiert oder unsubstituiert sein können. Hier kommen Fluoren-Derivate (z. B. EP 0842208, WO 99/54385, WO 00/22027, WO 00/22026, WO 00/46321) in Betracht. Des Weiteren sind auch Spirobifluoren-Derivate (z. B. EP 0707020, EP 0894107, WO 03/020790) eine Möglichkeit. Auch Polymere, die eine Kombination der beiden erstgenannten Monomer-Einheiten enthalten (WO 02/077060), wurden bereits vorgeschlagen. In WO 05/014689 sind Dihydrophenanthren-Derivate beschrieben. Weiterhin kommen cis- oder trans-Indenofluoren-Derivate (z. B. GB 0226010.7, WO 04/113412) in Frage, aber zum Beispiel auch Dihydropyren- oder Tetrahydropyren-Derivate und weitere nicht explizit aufgeführte aromatische Strukturen.
Gruppe 2: Einheiten, welche die Morphologie bzw. die Emissionsfarbe verändern:
   Es sind auch Strukturelemente möglich, die die Morphologie, aber auch die Emissionsfarbe der resultierenden Polymere beeinflussen können. Bevorzugt sind dabei substituierte oder unsubstituierte aromatische Strukturen mit 6 bis 40 C-Atomen oder auch Tolan-, Stilben- oder Bisstyrylarylenderivate, wie z. B. 1,4-Phenylen-, 1,4-Naphthylen-, 1,4- oder 9,10-Anthrylen-, 1,6- oder 2,7- oder 4,9-Pyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilbenylen-oder 4,4"-Bisstyrylarylenderivate.
Gruppe 3: Einheiten, welche die Lochinjektions- und/oder -transporteigenschaften der Polymere erhöhen:
   Dies sind im Allgemeinen aromatische Amine oder elektronenreiche Heterocyclen, wie beispielsweise substituierte oder unsubstituierte Triarylamine, Benzidine, N,N,N',N'-Tetraaryl-para-phenylendiamine, Triarylphosphine, Phenothiazine, Phenoxazine, Dihydrophenazine, Thianthrene, Dibenzo-p-dioxine, Phenoxathiine, Carbazole, Azulene, Thiophene, Pyrrole, Furane und weitere O-, S- oder N-haltige Heterocyclen mit hoch liegendem HOMO (HOMO = höchstes besetztes Molekülorbital). Da jedoch die Einheiten gemäß Formel (1) bereits lochleitende Eigenschaften besitzen, können die erfindungsgemäßen Polymere auch ohne die zusätzliche Verwendung weiterer Lochtransporteinheiten eine ausreichende Lochleitfähigkeit aufweisen.
Gruppe 4: Einheiten, welche die Elektroneninjektions- und/oder -transporteigenschaften der Polymere erhöhen:
   Dies sind im Allgemeinen elektronenarme Aromaten oder Heterocyclen, wie beispielsweise substituierte oder unsubstituierte Pyridine, Pyrimidine, Pyridazine, Pyrazine, Oxadiazole, Chinoline, Chinoxaline, Benzothiadiazole oder Phenazine, aber auch Verbindungen wie Triarylborane und weitere O-, S- oder N-haltige Heterocyclen mit niedrig liegendem LUMO (LUMO = niedrigstes unbesetztes Molekülorbital).
Gruppe 5: Einheiten, die Kombinationen von Einzeleinheiten der Gruppe 3 und Gruppe 4 aufweisen:
   Es kann auch bevorzugt sein, wenn in den erfindungsgemäßen Polymeren Einheiten enthalten sind, in denen Strukturen, welche die Lochmobilität und welche die Eiektronenmobilität erhöhen, direkt aneinander gebunden sind. Einige dieser Einheiten verschieben die Emissionsfarbe ins Grüne, Gelbe oder Rote; ihre Verwendung eignet sich also beispielsweise für die Erzeugung anderer Emissionsfarben aus ursprünglich blau emittierenden Polymeren.
Gruppe 6: Einheiten, die aus dem Triplett-Zustand Licht emittieren, bzw. welche den Transfer vom Singulett- zum Triplett-Zustand verbessern Struktureinheiten aus Gruppe 6 sind solche, welche auch bei Raumtemperatur mit hoher Effizienz aus dem Triplettzustand Licht emittieren können, also Elektrophosphoreszenz statt Elektrofluoreszenz zeigen. Hierfür eignen sich zunächst Verbindungen, welche Schweratome mit einer Ordnungszahl von mehr als 36 enthalten. Besonders geeignet sind Verbindungen, welche d- oder f-Übergangsmetalle beeinhalten, die diese Bedingung erfüllen. Ganz besonders bevorzugt sind Struktureinheiten, welche Elemente der Gruppe 8 bis 10 (Ru, Os, Rh, Ir, Pd, Pt) enthalten, insbesondere Iridium und/oder Platin. Diese Metallkomplexe können in die Hauptkette und/oder in die Seitenkette des Polymers gebunden werden.
Für den Einsatz solcher Strukturelemente ist es bevorzugt, unterstützend weitere Strukturelemente einzusetzen, welche den Übergang vom Singulett- zum Triplett-Zustand und damit die Elektrophosphoreszenzeigenschaften verbessern. Hierfür kommen beispielsweise Carbazoleinheiten, bevorzugt überbrückte Carbazoldimereinheiten, in Frage, wie in WO 04/070772 und WO 04/113468 beschrieben, aber beispielsweise auch Keto-Einheiten, wie in der nicht offen gelegten Anmeldung DE 10349033.7 beschrieben.

Bevorzugt sind erfindungsgemäße Polymere, die neben Struktureinheiten gemäß Formel (1) zusätzlich noch eine oder mehrere Einheiten ausgewählt aus den Gruppen 1 bis 6 enthalten. Dabei kann es auch vorteilhaft sein, wenn gleichzeitig mehr als eine Struktureinheit aus einer der Gruppen 1 bis 6 vorliegt. Besonders bevorzugt sind Polymere, die neben Einheiten gemäß Formel (1) noch Einheiten aus der Gruppe 1 enthalten, ganz besonders bevorzugt mindestens 50 mol% dieser Einheiten. Die Einheiten aus der Gruppe 1 sind bevorzugt ausgewählt aus Spirobifluoren, Fluoren, Dihydrophenanthren, cis-Indenofluoren und/oder trans-Indenofluoren, die substituiert oder unsubstituiert sein können.

Bevorzugt ist ein Anteil von 1 - 50 mol% Einheiten gemäß Formel (1). Besonders bevorzugt ist ein Anteil von 5 - 30 mol% Einheiten gemäß Formel (1), ganz besonders bevorzugt ein Anteil von 7 - 15 mol%. Dieser Anteil hat sich insbesondere für elektrolumineszierende Polymere als besonders geeignet erwiesen. Für andere Anwendungen, wie beispielsweise für Ladungstransportpolymere in verschiedenen Anwendungen, kann ein deutlich höherer Anteil Einheiten gemäß Formel (1) geeignet sein, beispielsweise bis zu 100 mol% Einheiten gemäß Formel (1).

Bevorzugt sind weiterhin erfindungsgemäße Polymere, bei denen für das Symbol X, gleich oder verschieden bei jedem Auftreten, für eine Einheit gemäß Formel (3) steht, 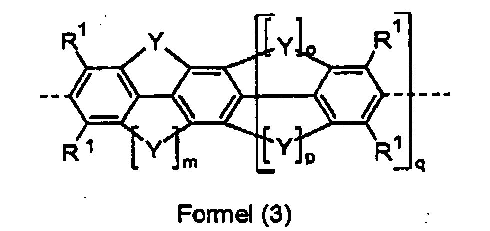 wobei für die verwendeten Symbole und Indizes gilt:
- Y: ist bei jedem Auftreten gleich oder verschieden -C(R¹)₂-, -C(R¹)₂-C(R¹)₂-, -N(R¹)-, -O-, -S-, -P(R¹)-, -P(=O)(R¹)-, -O-C(R¹)₂- oder -O-C(=O)-, bevorzugt -C(R¹)₂- oder -C(R¹)₂-C(R¹)₂-;
- m: ist bei jedem Auftreten gleich oder verschieden 0 oder 1, bevorzugt 0, wobei im Fall, dass der Index m = 0 ist, der Rest Y entfällt und keiner chemischen Bindung entspricht;
- o, p: sind bei jedem Auftreten gleich oder verschieden 0 oder 1, mit der Maßgabe, dass o und p nicht gleichzeitig 0 sein dürfen, wobei im Fall, dass einer der Indizes o oder p = 0 ist, der Rest Y entfällt und keiner chemischen Bindung entspricht;
- q: ist bei jedem Auftreten gleich oder verschieden 0, 1 oder 2, bevorzugt 0 oder 1;
dabei stellt die gestrichelte Bindung in Formel (3) die Verknüpfung dieser Formel mit dem Atom A in Struktureinheiten gemäß Formel (1) dar.

Weiterhin bevorzugt sind erfindungsgemäße Polymere, bei denen die Symbole Ar¹ bis Ar⁵, bei jedem Auftreten gleich oder verschieden für ein aromatisches oder heteroaromatisches Ringsystem mit 4 bis 30 C-Atomen steht, das mit R¹ substituiert sein kann, bevorzugt für ein aromatisches oder heteroaromatisches Ringsystem mit 6 bis 25 C-Atomen, das mit R¹ substituiert sein kann.

Weiterhin bevorzugt steht der Index n bevorzugt für 0 oder 1, besonders bevorzugt für 0.

Weiterhin bevorzugt sind symmetrische Einheiten gemäß Formel (1). Diese Bevorzugung ist durch die leichtere synthetische Zugänglichkeit der Monomere zu begründen. Bevorzugt gilt also, dass in einer Einheit gemäß Formel (1) die Einheiten bezüglich Ar¹ bis Ar⁵ symmetrisch aufgebaut sind. Wenn mehrere Einheiten X auftreten, so sind auch diese bevorzugt gleich zu wählen.

Beispiele für Einheiten gemäß Formel (1) sind Strukturen gemäß den abgebildeten Beispielen (1) bis (27), wobei die gestrichelten Bindungen eine Verknüpfung im Polymer bedeuten. Mögliche Substituenten sind für die bessere Übersichtlichkeit im Allgemeinen nicht aufgeführt, können aber aus synthetischen Gründen, für die Löslichkeit, für die Effizienz oder die Stabilität der Systeme durchaus bevorzugt sein.

| | | |
|---|---|---|
| 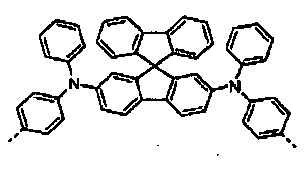 | 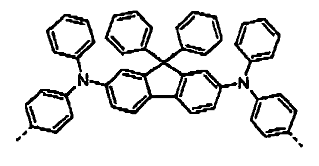 | 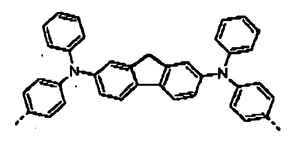 |
| Beispiel 1 | Beispiel 2 | Beispiel 3 |
| 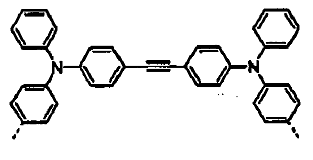 | 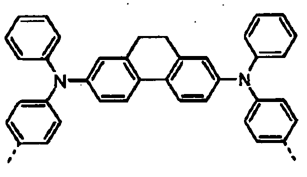 | 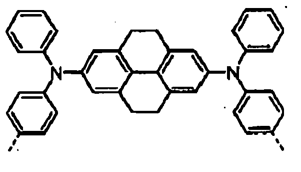 |
| Beispiel 4 | Beispiel 5 | Beispiel 6 |
| 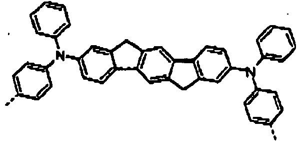 | 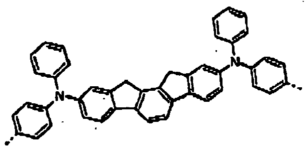 | 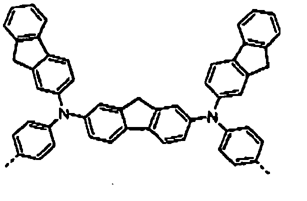 |
| Beispiel 7 | Beispiel 8 | Beispiel 9 |
| 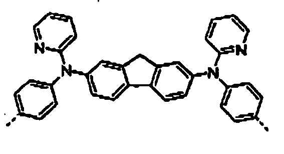 | 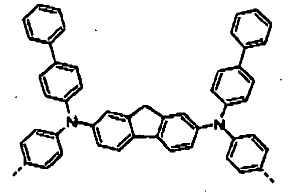 | 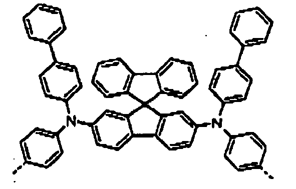 |
| Beispiel 10 | Beispiel 11 | Beispiel 12 |
| 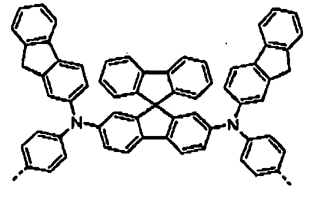 | 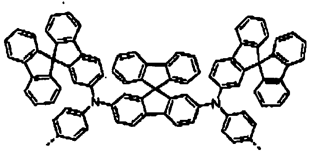 | 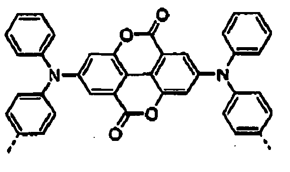 |
| Beispiel 13 | Beispiel 14 | Beispiel 15 |
| 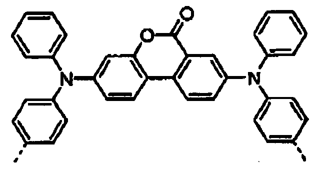 | 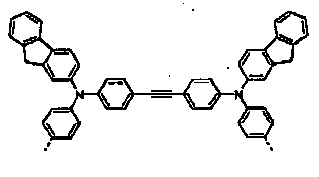 | 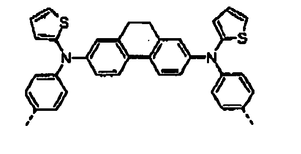 |
| Beispiel 16 | Beispiel 17 | Beispiel 18 |
| 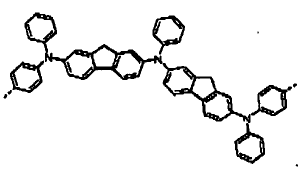 | 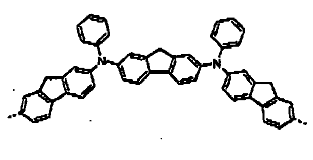 | 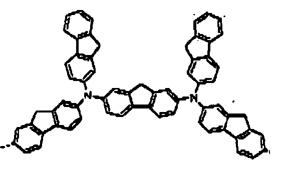 |
| Beispiel 19 | Beispiel 20 | Beispiel 21 |
| 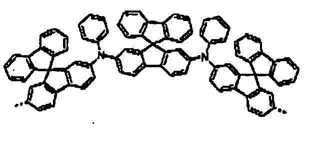 | 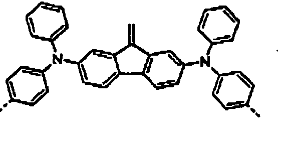 | 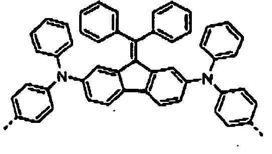 |
| Beispiel 22 | Beispiel 23 | Beispiel 24 |
| 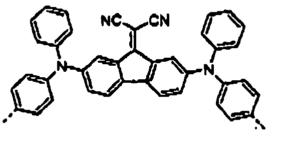 | 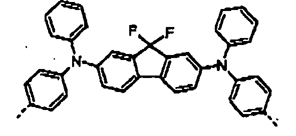 | 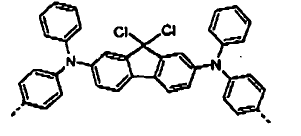 |
| Beispiel 25 | Beispiel 26 | Beispiel 27 |

Die erfindungsgemäßen Polymere sind entweder Homopolymere aus Einheiten gemäß Formel (1) oder Copolymere. Erfindungsgemäße Copolymere können dabe neben einer oder mehreren Strukturen gemäß Formel (1) potenziell eine oder mehrere weitere Strukturen aus den oben aufgeführten Gruppen 1 bis 6 besitzen.
Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können, ist beispielsweise ausführlich in WO 05/014688 beschrieben. Diese ist via Zitat Bestandteil der vorliegenden Anmeldung. Ebenso sei an dieser Stelle hervorgehoben, dass das Polymer nicht linear aufgebaut sein muss, sondern auch verzweigt sein kann, bzw. auch dendritische Strukturen aufweisen kann.

Die erfindungsgemäßen Polymere weisen bevorzugt 10 bis 10000, besonders bevorzugt 20 bis 5000, ganz besonders bevorzugt 50 bis 2000 Wiederholeinheiten auf.

Die erfindungsgemäßen Polymere werden in der Regel durch Polymerisation von einer oder mehreren Monomersorten hergestellt, von denen mindestens ein Monomer im Polymer zu Einheiten gemäß Formel (1) führt. Entsprechende Polymensationsreaktionen gibt es prinzipiell viele. Es haben sich hier jedoch einige Typen besonders bewährt, die zu C-C- bzw. zu C-N-Verknüpfungen führen:
(A) Polymerisation gemäß SUZUKI;
(B) Polymerisation gemäß YAMAMOTO;
(C) Polymerisation gemäß STILLE;
(D) Polymerisation gemäß HARTWIG-BUCHWALD.

Wie die Polymerisation nach diesen Methoden durchgeführt werden kann und wie die Polymere vom Reaktionsmedium abgetrennt und aufgereinigt werden können, ist beispielsweise im Detail in WO 03/048225 oder WO 04/022626 beschrieben.

Zur Synthese der Polymere werden die entsprechenden Monomere benötigt. Für die Synthese von Einheiten aus Gruppe 1 bis 6 sei auf WO 05/014689 und die darin zitierte Literatur verwiesen.

Monomere, die in erfindungsgemäßen Polymeren zu Struktureinheiten gemäß Formel (1) führen, sind entsprechende Triarylaminderivate (bzw. die entsprechenden Phosphor- und Arsen-Derivate), die an geeigneten Positionen geeignet substituiert sind und geeignete Funktionalitäten aufweisen, die es erlauben, diese Monomereinheit in das Polymer einzubauen.

Diese Monomere sind bifunktionelle monomere Verbindungen gemäß Formel (4) und Formel (5), 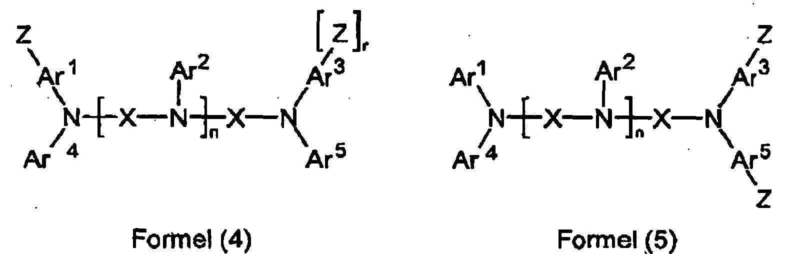 wobei X, Ar¹, Ar², Ar³, Ar⁴, Ar⁵, R¹, R² und n dieselbe Bedeutung haben, wie unter Formel (1) beschrieben, und weiterhin gilt:
- Z: ist bei jedem Auftreten gleich oder verschieden eine funktionelle Gruppe, die unter Bedingungen der C-C- bzw. der C-N-Verknüpfungen copolymerisiert, bevorzugt Cl, Br, I, O-Tosylat, O-Triflat, O-SO₂R¹, B(OR¹)₂ oder Sn(R¹)₃, besonders bevorzugt Br, I, B(OR¹)₂ oder Sn(R¹)₃;
- r: ist 0 oder 1.

Die C-C-Verknüpfungen sind bevorzugt ausgewählt aus den Gruppen der SUZUKI-Kupplung, der YAMAMOTO-Kupplung und der STILLE-Kupplung; die C-N-Verknüpfung ist bevorzugt eine Kupplung gemäß HARTWIG-BUCHWALD.

Dabei gilt für bifunktionelle monomere Verbindungen gemäß Formel (4) und Formel (5) dieselbe Bevorzugung, wie für Struktureinheiten gemäß Formel (1) oben beschrieben.

Es kann außerdem bevorzugt sein, das erfindungsgemäße Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren. Aber auch elektronisch inerte Blendbestandteile können sinnvoll sein, um beispielsweise die Viskosität einer Lösung oder die Morphologie des gebildeten Films zu kontrollieren. Solche Blends sind daher auch Bestandteil der vorliegenden Erfindung.

Gegenstand der Erfindung sind weiterhin Lösungen und Formulierungen aus einem oder mehreren erfindungsgemäßen Polymeren oder Blends in einem oder mehreren Lösungsmitteln. Wie Polymerlösungen hergestellt werden können, ist beispielsweise in WO 02/072714, WO 031019694 und der darin zitierten Literatur beschrieben. Diese Lösungen können verwendet werden, um dünne Polymerschichten herzustellen, zum Beispiel durch Flächenbeschichtungsverfahren (z. B. Spincoating) oder durch Druckverfahren (z. B. InkJet Printing).

Die erfindungsgemäßen Polymere und Blends können in PLEDs verwendet werden. Wie PLEDs hergestellt werden können, wird als allgemeines Verfahren ausführlich in WO 04/037887 beschrieben, das entsprechend für den Einzelfall anzupassen ist. Wie oben beschrieben, eignen sich die erfindungsgemäßen Polymere ganz besonders als Elektrolumineszenzmaterialien in derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport von positiven und/oder negativen Ladungen verbessert (Ladungsinjektions- oder Ladungstransportschicht). Auch eine Verwendung als "Pufferschicht" zwischen einer Emissionsschicht und einer Lochinjektionsschicht ist möglich.

Gegenstand der Erfindung ist daher auch die Verwendung eines erfindungsgemäßen Polymers oder Blends in einer PLED, insbesondere als emittierendes Material.

Gegenstand der Erfindung ist weiterhin eine PLED mit einer oder mehreren aktiven Schichten, wobei mindestens eine dieser aktiven Schichten ein oder mehrere erfindungsgemäße Polymere oder Blends enthält. Die aktive Schicht kann beispielsweise eine lichtemittierende Schicht und/oder eine Transportschicht und/oder eine Ladungsinjektionsschicht sein.

Die erfindungsgemäßen Polymere weisen gegenüber den in WO 031020790 beschriebenen Poly-Spirobifluorenen, den in WO 02/077060 beschriebenen Polyfluorenen und den in WO 051014689 beschriebenen Poly-Dihydrophenanthrenen, die keine Einheiten gemäß Formel (1) enthalten und die hier als nächstliegender Stand der Technik genannt werden, folgende überraschenden Vorteile auf:
(1) Die Lebensdauer ist höher als bei vergleichbaren Polymeren, die bei ansonsten gleicher Zusammensetzung keine Einheiten gemäß Formel (1) enthalten, sondern statt dessen Bis(triarylamin)derivate, deren zentrale aromatische Einheit nicht planar aufgebaut ist. Eine Verbesserung der Lebensdauer ist für die Anwendung von enormer Bedeutung, da insbesondere bei blau und grün emittierenden Polymeren die unzureichende Lebensdauer bislang noch das größte Hindernis für eine Anwendung ist.
(2) Die erfindungsgemäßen Polymere weisen, bei ansonsten gleicher Zusammensetzung, vergleichbare oder höhere Leuchteffizienzen in der Anwendung auf. Dies ist von enormer Bedeutung, da somit entweder gleiche Helligkeit bei geringerem Energieverbrauch erzielt werden kann, was vor allem bei mobilen Anwendungen (Displays für Handys, Pager, PDA, etc.), die auf Batterien und Akkus angewiesen sind, sehr wichtig ist. Umgekehrt erhält man bei gleichem Energieverbrauch höhere Helligkeiten, was beispielsweise für Beleuchtungsanwendungen interessant sein kann.
(3) Die Strom-Spannungs-Kurven sind steiler, wenn Triarylamin-Einheiten mit planarer (und bevorzugt steifer) überbrückender Einheit verwendet werden. Die erfindungsgemäßen Triarylamin-Einheiten sind also bessere Lochleiter als Triarylamin-Einheiten gemäß dem Stand der Technik.

Im vorliegenden Anmeldetext und auch in den im Weiteren folgenden Beispielen wird auf die Verwendung erfindungsgemäßer Polymere in Bezug auf PLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter (oder bei geeigneter Dotierung auch Leiter) auch für weitere Verwendungen in anderen elektronischen Devices (Vorrichtungen) zu benutzen, z. B. in organischen Feld-Effekt-Transistoren (O-FETs), organischen integrierten Schaltungen (O-ICs), organischen Dünnfilmtransistoren (O-TFTs), organischen Solarzellen (O-SCs), organische Feld-Quench-Devices (O-FQD) oder auch organischen Laserdioden (O-Laser), um nur einige Anwendungen zu nennen. Die Verwendung der erfindungsgemäßen Polymere in den entsprechenden Vorrichtungen ist ebenfalls Gegenstand der vorliegenden Erfindung. Ebenso Gegenstand der Erfindung sind also organische Feld-Effekt-Transistoren (O-FETs), organische integrierte Schaltungen (O-ICs), organische Dünnfilmtransistoren (O-TFTs), organische Solarzellen (O-SCs), organische Feld-Quench-Devices (O-FQDs) und organische Laserdioden (O-Laser), enthaltend mindestens ein erfindungsgemäßes Polymer.

### Beispiele:

### Beispiel 1: Synthese von N,N'-Bis(4-bromphenyl)-N,N'-bis(4-tert-butylphenyl)-9,9-dioctylfluoren-2,7-diamin (erfindungsgemäßes Monomer EM1)

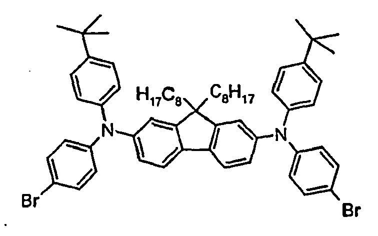

a) N,N'-Diphenyl-N,N'-bis(4-*tert*-butylphenyl)-9,9-dioctylfluoren-2,7-diamin
   Eine entgaste Lösung aus 26 g (47.4 mmol) 2,7-Dibrom-9,9-dioctylfluoren (synthetisiert gemäß M. Ranger, M. Leclerc, Chem. Commun. 1997, 1597) und 20.2 g (91 mmol) 4-*tert*-Butylphenyl-phenyl-amin (synthetisiert gemäß J. Org. Chem. 2003, 68, 452) in 150 mL Toluol wurde 1 h mit N₂ gesättigt. Danach wurde die Lösung zuerst mit 174 mg (0.86 mmol) P(^{t}Bu)₃, dann mit 96 mg (0.42 mmol) Pd(OAc)₂ versetzt; anschließend wurden 5.4 g (56 mmol) NaO^{t}Bu im festen Zustand zugegeben. Die Reaktionsmischung wurde 5 h unter Rückfluss erhitzt. Nach Abkühlen auf Raumtemperatur wurden vorsichtig 0.8 g NaCN und 40 mL Wasser zugesetzt. Die organische Phase wurde mit 4 x 50 mL H₂O gewaschen, über MgSO₄ getrocknet und die Lösungsmittel in Vakuum entfernt. Nach chromatographischer Reinigung über Kieselgel erhielt man ein gelbes Öl. Die Ausbeute - bei einer Reinheit von 99.3 % nach HPLC - betrug 33 g (85 % d. Th.).
   ¹H-NMR (CDCl₃, 500 MHz): 0.65 (m, 4H), 0.83 (t, J = 7.03 Hz, 6H), 0.99-1.28 (m, 20H),1.31 (s, 18H), 1.71-1.79 (m, 4H), 6.90-7.11 (m, 12H), 7.21-7.31 (m, 10H), 7.40-7.51 (m, 2H).
b) N,N'-Bis(4-bromphenyl)-N,N'-bis(4-*tert*-butylphenyl)-9,9-dioctylfluoren-2,7-diamin **(EM1)**
   36.6 g (43.7 mmol) N,N'-Diphenyl-N,N'-bis-(4-*tert*-butylphenyl)-9,9-dioctylfluoren-2,7-diamin wurden in 500 mL THF vorgelegt. Anschließend tropfte man unter Lichtausschluss bei 0 °C eine Lösung aus 15.15 g (84.4 mmol) NBS, gelöst in 300 mL THF zu; ließ auf Raumtemperatur kommen und rührte weitere 4 h. Anschließend wurde die Mischung mit 500 mL Wasser versetzt und mit CH₂Cl₂ extrahiert. Die organische Phase wurde über MgSO₄ getrocknet und die Lösungsmittel in Vakuum entfernt. Das Produkt wurde mit Hexan heiß ausgerührt und abgesaugt. Man erhielt 35 g (68 % d. Th.) eines weißen Feststoffs, welcher nach mehrmaliger Umkristallisation aus Ethylacetat eine HPLC-Reinheit von 99.9 % aufwies.
   ¹H-NMR (CDCl₃, 500 MHz): 0.66 (m, 4H), 0.85 (t, J = 7.03 Hz, 6H), 0.99-1.28 (m, 20H),1.33 (s, 18H), 1.73-1.79 (m, 4H), 6.85-7.10 (m, 12H), 7.21-7.35 (m, 8H), 7.40-7.51 (m, 2H).

### Beispiel 2: Synthese von N,N'-Bis(4-bromphenyl)-N,N'-bis(4-tert-butylphenyl)-9,10-dibutyl-9,10-dimethoxy-9,10-dihydrophenanthren-2,7-diamin (erfindungsgemäßes Monomer EM2)

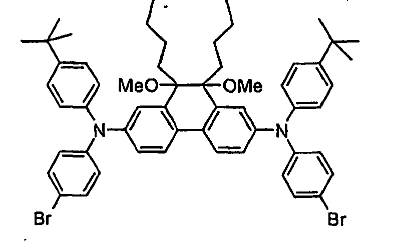

a) N,N'-Diphenyl-N,N'-bis(4-tert-butylphenyl)-9,10-dibutyl-9,10-dimethoxy-9,10-dihydrophenanthren-2,7-diamin
   Die Synthese erfolgte in Analogie zu Beispiel 1a), wobei als Edukt 24.2 g (47.4 mmol) 2,7-Dibrom-9,10-dibutyl-9,10-dimethoxy-9,10-dihydrophenanthren (synthetisiert gemäß WO 05/014689) eingesetzt wurden. Nach chromatographischer Reinigung über Kieselgel erhielt man ein gelbes Öl. Die Ausbeute - bei einer Reinheit von 99.0 % nach HPLC - betrug 30 g (81 % d. Th.).
   ¹H-NMR (CDCl₃, 500 MHz): 0.53 (m, 2H), 0.81 (t, J = 7.03 Hz, 6H), 0.94-1.19 (m, 6H), 1.25 (s, 18H), 1.62 (m, 2H), 2.05 (t, J = 7.03 Hz, 2H), 3.31 (s, 6H), 6.61-7.5 (m, 24H).
b) N,N'-Bis(4-bromphenyl)-N,N'-bis(4-*tert*-butylphenyl)-9,10-dibutyl-9,10-dimethoxy-9,10-dihydrophenanthren-2,7-diamin **(EM2)**
   Die Synthese erfolgte in Analogie zu Beispiel 1b), wobei als Edukt 34.9 g (43.7 mmol) N,N'-Diphenyl-N,N'-bis(4-tert-butylphenyl)-9,10-dibutyl-9,10-dimethoxy-9,10-dihydrophenanthren-2,7-diamin eingesetzt wurden. Man erhielt 24 g (70 % d. Th.) eines weißen Feststoffs, welcher nach mehrmaliger Umkristallisation aus Ethylacetat eine HPLC-Reinheit von 99.9 % aufwies.
   ¹H-NMR (CDCl₃, 500 MHz): 0.53 (m, 2H), 0.81 (t, J = 7.03 Hz, 6H), 0.94-1.19 (m, 6H), 1.25 (s, 18H), 1.62 (m, 2H), 2.05 (t, J = 7.03 Hz, 2H), 3.31 (s, 6H), 6.85-7.05 (m, 10H), 7.11-7.20 (m, 2H), 7.25-7.33 (m, 8H), 7.42-7.48 (m, 2H).

### Beispiel 3: Synthese von N,N'-Bis(4-bromphenyl)-N,N'-bis(4-tert-butylphenyl)-2',7'-bis(tert-butyl)-9,9'-spirobifluoren-2,7-diamin (erfindungsgemäßes Monomer EM3)

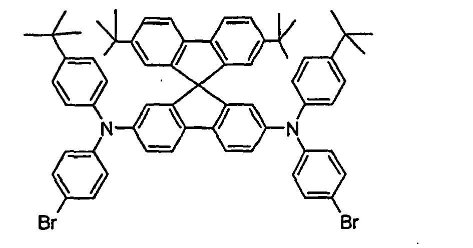

a) N,N'-Diphenyl-N,N'-bis(4-*tert*-butylphenyl)-2',7'-bis(*tert*-butyl)-9,9'-spirobifluoren-2,7-diamin
   Die Synthese erfolgte in Analogie zu Beispiel 1a), wobei als Edukt 31.0 g (54 mmol) 2,7-Dibromo-2',7'-bis(*tert*-butyl)-9,9'-spirobifluoren eingesetzt wurden. Nach chromatographischer Reinigung über Kieselgel erhielt man ein gelbes Öl. Die Ausbeute - bei einer Reinheit von 99.2 % nach HPLC - betrug 50 g (99 % d. Th.). ¹H-NMR (Aceton-d₆, 500 MHz): 1.28 (s, 36H), 6.39 (s, 2H), 6.81-6.89 (m, 12H), 6.98 (dd, J = 2 Hz, J = 8.3 Hz, 2H), 7.05-7.20 (m, 12H), 7.34 (dd, J = 1.7 Hz, J = 8.0 Hz, 2H), 7.06 (d, J = 8.0 Hz, 2H), 7.79 (d, J = 8.3 Hz, 2H).
b) N,N'-Bis(4-bromphenyl)-N,N'-bis(4-*tert*-butylphenyl)-2',7'-bis(*tert*-butyl)-9,9'-spirobifluoren-2,7-diamin **(EM3)**
   Die Synthese erfolgte in Analogie zu Beispiel 1b), wobei als Edukt 52 g (60.8 mmol) N,N'-Diphenyl-N,N'-bis(4-*tert*-butylphenyl)-2',7;-bis(*tert*-butyl)-9,9'-spirobifluoren-2,7-diamin eingesetzt wurden. Man erhielt 68 g (97.5 % d. Th.) eines weißen Feststoffs, welcher nach mehrmaliger Umkristallisation aus Ethylacetat eine HPLC-Reinheit von 99.8 % aufwies.
   ¹H-NMR (CDCl₃, 500 MHz): 1.25 (s, 36H), 6.49 (s, 2H), 6.65-7.15 (m, 20H), 7.32 (dd, J = 1.6 Hz, J = 8.0 Hz, 2H), 7.56 (d, J = 8.0 Hz, 2H), 7.66 (s, J = 8.0 Hz, 2H).

### Beispiel 4: Synthese weiterer Comonomere

Die Strukturen der weiteren Monomere (**M**) für erfindungsgemäße Polymere und Vergleichspolymere sind im Folgenden abgebildet. Die Synthese der Monomere **M1** bis **M6** ist in WO 031020790, in WO 05/014689 und der darin zitierten Literatur beschrieben.

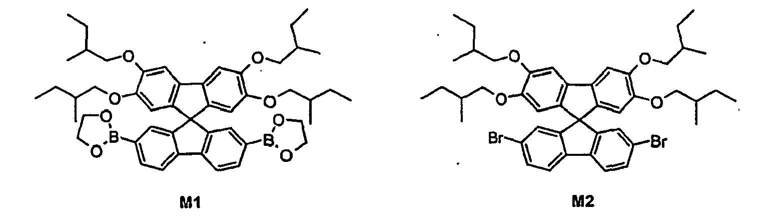

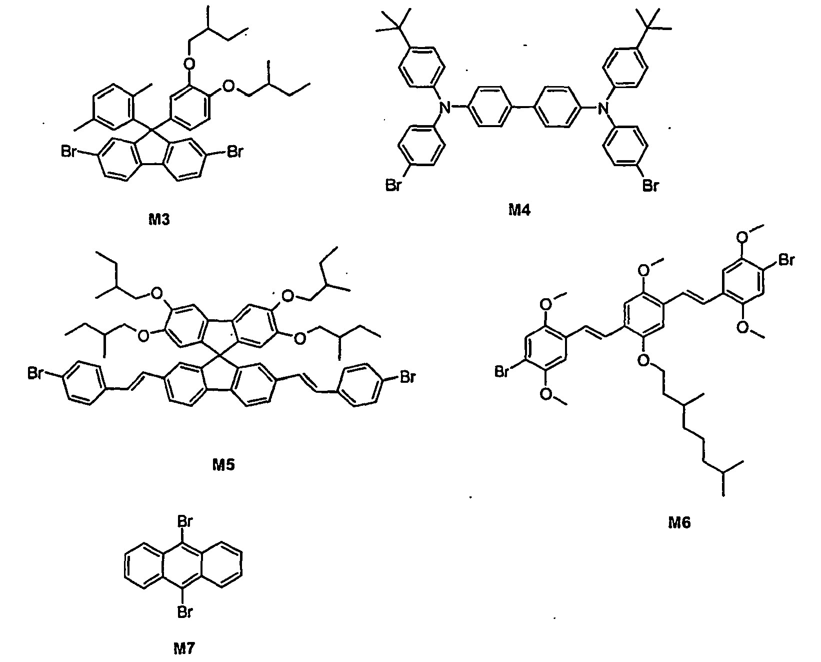

### Beispiel 5: Synthese der Polymere

Die Polymere wurden durch SUZUKI-Kupplung gemäß WO 03/048225 synthetisiert. Die Zusammensetzung der synthetisierten Polymere **P1** bis **P5** ist in Tabelle 1 zusammengefasst. Außerdem wurden die Vergleichspolymere **V1** bis **V5** synthetisiert, die statt der erfindungsgemäßen Monomere **EM1** und **EM2** das Monomer **M4** enthalten. Die Zusammensetzung der Vergleichspolymere ist ebenfalls in Tabelle 1 aufgeführt.

### Beispiel 6: Herstellung der PLEDs

Die Polymere wurden für einen Einsatz in PLEDs untersucht. Die PLEDs waren jeweils Zweischichtsysteme, d. h. Substrat//ITOI/PEDOT//Polymer//Kathode. PEDOT ist ein Polythiophen-Derivat (Baytron P, von H. C. Stark, Goslar). Als Kathode wurde in allen Fällen Ba/Ag (Aldrich) verwendet. Wie PLEDs dargestellt werden können, ist in WO 04/037887 und der darin zitierten Literatur ausführlich beschrieben.

### Beispiel 7 bis 11: Device-Beispiele

Die Ergebnisse, die bei Verwendung der Polymere **P1** bis **P5** in PLEDs erhalten wurden, sind in Tabelle 1 zusammengefasst. Ebenso aufgeführt sind die Elektrolumineszenz-Ergebnisse, die unter Verwendung der Vergleichspolymere **V1** bis **V5** erhalten wurden. Da die Emissionsfarben der erfindungsgemäßen und Vergleichspolymere nicht immer identisch sind, wurden für die blau emittierenden Polymere für die Lebensdauer korrigierte Werte angegebenen, die sich auf eine Anfangshelligkeit von 400 cd/m² und eine y-Farbkoordinate von 0.2 beziehen, um eine bessere Vergleichbarkeit zu erhalten.

Wie man deutlich sieht, sind die erfindungsgemäßen Polymere, die erfindungsgemäße planare Triarylamin-Einheiten gemäß Formel (1) enthalten, in der Elektrolumineszenz deutlich besser als Polymere, die Triarylamin-Einheiten gemäß dem Stand der Technik enthalten, insbesondere in der Lebensdauer. So wird in der Lebensdauer eine Verbesserung bis zu einem Faktor von mehr als 6 (Polymer **P2** bzw. **V2**) beobachtet. Dieser Effekt ist nicht bei allen Polymeren so stark ausgeprägt, aber bei allen erfindungsgemäßen Polymeren ist eine deutliche Erhöhung der Lebensdauer zu beobachten.

**Tabelle 1: Device-Ergebnisse mit erfindungsgemäßen Polymeren und Vergleichpolymeren**

| Beispiel | Polymer | Amin | weitere Monomere | Max. Eff. / cd/A | U @ 100 cd/m² / V | CIE x/y^{a} | korrigierte Lebensdauer^{b} / h |
|---|---|---|---|---|---|---|---|
| 7 | **P1** | 10% **EM1** | 50% **M1**, 40% **M2** | 3.95 | 4.9 | 0.16 / 0.23 | 53 |
| 7 (Vergleich) | **V1** | 10% **M4** | 50% **M1,** 40% **M2** | 2.86 | 4.4 | 0.16 / 0.18 | 24 |
| 8 | **P2** | 10% **EM1** | 50% **M1,** 40% **M3** | 3.78 | 4.1 | 0.17 / 0.24 | 105 |
| 8 (Vergleich) | **V2** | 10% **M4** | 50% **M1,** 40% **M3** | 2.97 | 5.7 | 0.15 / 0.15 | 17 |
| 9 | **P3** | 10% **EM1** | 50% **M1,** 30% **M2,** 10% **M7** | 3.70 | 4.8 | 0.17 / 0.24 | 55 |
| 9 (Vergleich) | **V3** | 10% **M4** | 50% **M1,** 30% **M2,** 10% **M7** | 2.97 | 4.5 | 0.16 / 0.21 | 12 |
| 10 | **P4** | 10% **EM1** | 50% **M1,** 30% **M3,** 10% **M5** | 4.36 | 4.3 | 0.21 / 0.36 | 102 |
| 10 (Vergleich) | **V4** | 10% **M4** | 50% **M1,** 30% **M3,** 10% **M5** | 4.38 | 3.8 | 0.19 / 0.31 | 80 |
| 11 | **P5** | 10% **EM1** | 50% **M1,** 20% **M3,** 20% **M6** | 9.24 | 3.4 | 0.32 / 0.57 | 883 |
| 11 (Vergleich) | **V5** | 10% **M4** | 50% **M1,** 20% **M3,** 20% **M6** | 8.29 | 3.1 | 0.33 / 0.58 | 384 |

| | | | | | | | |
|---|---|---|---|---|---|---|---|
| ^{a} CIE-Koordinaten: Farbkoordinaten der Commision Internationale de l'Eclairage 1931. ^{b} Lebensdauer: Zeit bis zum Abfall der Helligkeit auf 50 % der Anfangshelligkeit. Die korrigierte Lebensdauer bezieht sich auf eine Energiedichte von 6.6 W/m², also auf eine Helligkeit von 400 cd/m² bei einer y-CIE-Farbkoordinate 0.2. Die korrigierte Lebensdauer iässt sich aus der tatsächilich gemessenen Lebensdauer, aus der Anfangshelligkeit und aus den Farbkoordinatefi berechnen. | | | | | | | |

### Beispiel 12: Vergleich der Strom-Spannungs-Kurven

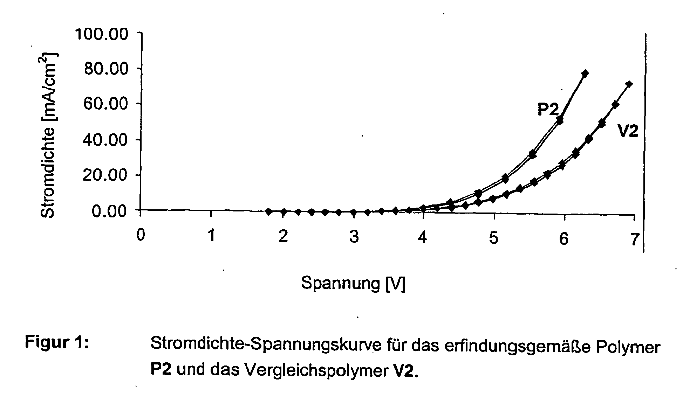

Die Stromdichte-Spannungs-Kurven für das Polymer **P2** und das Vergleichspolymer **V2** sind in Figur 1 gezeigt. Wie man sieht, ist die Kurve für das Polymer **P2,** das erfindungsgemäße Triarylamin-Einheiten enthält, deutlich steiler als für das Vergleichspolymer **V2,** das Triarylamin-Einheiten gemäß dem Stand der Technik enthält. Man sieht also, dass die erfindungsgemäßen Triarylamin-Einheiten bessere Lochleiter sind.

## Patentansprüche

1. Konjugierte oder teilkonjugierte Polymere, enthaltend mindestens 0.1 mol% Einheiten gemäß Formel (1), 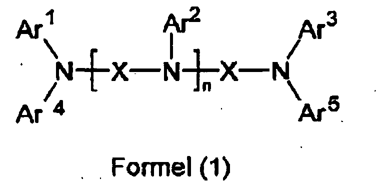 wobei die verwendeten Symbole und Indizes folgende Bedeutung besitzen:
X ist bei jedem Auftreten gleich oder verschieden ein bivalentes planares konjugiertes System mit 6 bis 40 C-Atomen, das mindestens zwei Arylengruppen enthält und das mit R¹ substituiert sein kann;
Ar¹, Ar², Ar³, Ar⁴, Ar⁵ ist bei jedem Auftreten gleich oder verschieden ein aromatisches Ringsystem mit 6 bis 40 C-Atomen, das mit einem oder mehreren Resten R¹ substituiert sein kann, oder ein hetero-aromatisches Ringsystem mit 2 bis 40 C-Atomen, das mit einem oder mehreren Resten R¹ substituiert sein kann, mit der Maßgabe, dass keine der Gruppen Ar¹ bis Ar⁵ ein kondensiertes Ringsystem darstellt, wenn diese Gruppe nicht eine direkte Bindung zur Polymerkette aufweist;
R¹ ist bei jedem Auftreten gleich oder verschieden H, F, Cl, Br, I, CN, NO₂, OH, N(R¹)₂, Si(R²)₃, B(R²)₂, eine geradkettige, verzweigte oder cyclische Alkyl-, Alkoxy- oder Thioalkoxygruppe mit 1 bis 40 C-Atomen, in der auch ein oder mehrere nicht benachbarte C-Atome durch -CR²=CR²-, -C≡C-, -NR²-, -O-, -S-, -CO-O- oder -O-CO-O- ersetzt sein können, wobei auch ein oder mehrere H-Atome durch Fluor ersetzt sein können, eine Aryl-, Heteroaryl-, Aryloxy- oder Heteroaryloxygruppe mit 2 bis 40 C-Atomen, bei der auch ein oder mehrere C-Atome durch O, S oder N ersetzt sein können und welche auch durch einen oder mehrere nicht-aromatische Reste R¹ substituiert sein kann; dabei können auch zwei oder mehrere der Reste R¹ miteinander ein aliphatisches oder aromatisches, mono- oder polycyclisches Ringsystem bilden;
R² ist bei jedem Auftreten gleich oder verschieden H oder ein aliphatischer oder aromatischer Kohlenwasserstoffrest mit 1 bis 20 C-Atomen;
n ist bei jedem Auftreten gleich oder verschieden 0, 1 oder 2;
die Verknüpfung der Einheiten gemäß Formel (1) mit dem Polymer erfolgt über eine oder zwei der Gruppen Ar¹ bis Ar⁵;
ausgenommen Polymere gemäß Formel (2), 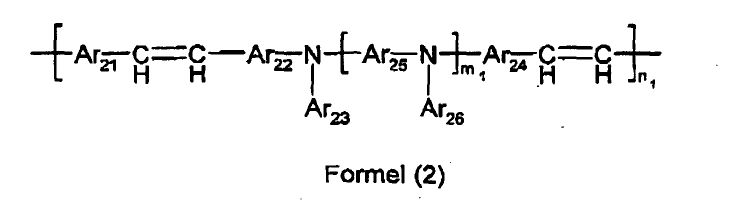 worin gilt Ar₂₁, Ar₂₂, Ar₂₄ sind jeweils eine Arylengruppe, die einen Substituenten tragen kann; Ar₂₅ ist eine Arylengruppe oder eine bivalente polykondensierte Ringgruppe, die einen Substituenten tragen kann; Ar₂₃ und Ar₂₆ sind jeweils eine Alkylgruppe, eine Aralkylgruppe oder eine Arylgruppe, die einen Substituenten tragen kann; m₁ ist 0, 1, 2 oder 3; n₁ ist eine natürliche Zahl;
ausgenommen weiterhin konjugierte Polymere enthaltend mindestens 1 mol%, Einheiten gemäß Formel (1), 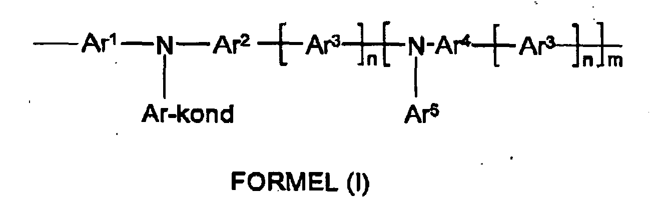 wobei die Symbole und Indizes folgende Bedeutung besitzen:
Ar¹, Ar³ sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
Ar², Ar⁴ sind bei jedem Auftreten gleich oder verschieden Ar¹, Ar³ bzw. einer substituierten bzw. unsubstituierten Stilbenylen- bzw. Tolanyleneinheit;
Ar-kond ist bei jedem Auftreten gleich oder verschieden einem aromatischen oder heteroaromatischen Ringsystem, welches mindestens 9, höchstens aber 40 Atome (C- oder Heteroatome) im konjugierten System besitzt, weiches substituiert oder auch unsubstituiert sein kann und welches aus mindestens zwei kondensierten Ringen besteht; die möglichen Substituenten R1 können dabei potentiell an jeder freien Position sitzen;
Ar⁵ ist gleich oder verschieden bei jedem Auftreten entweder einem aromatischen oder heteroaromatischen Ringsystem mit 2 bis 40 C-Atomen, welches substituiert oder auch unsubstituiert sein kann oder Ar-kond; die möglichen Substituenten R1 können dabei potentiell an jeder freien Position sitzen;
m, n sind gleich oder verschieden bei jedem Auftreten 0, 1 oder 2;
R1 ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R2, O, S, -CO-O-, O-CO-O ersetzt sein können, wobei auch ein oder mehrere H-Atome durch Fluor ersetzt sein können, eine Aryl- oder Acryloxygruppe mit 5 bis 40 C-Atomen, bei der auch ein oder mehrere C-Atome durch O, S oder N versetzt sein können, welche auch durch ein oder mehrere nicht-aromatische Reste R1 substituiert sein können, oder Cl, F, CN, N(R2)₂, B(R2)₂, wobei auch zwei oder mehrere Reste R1 miteinander ein Ringsystem bilden können;
R2 ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können.
mit der Maßgabe, das die Einheiten gemäß den Strukturen (1) bis (3) 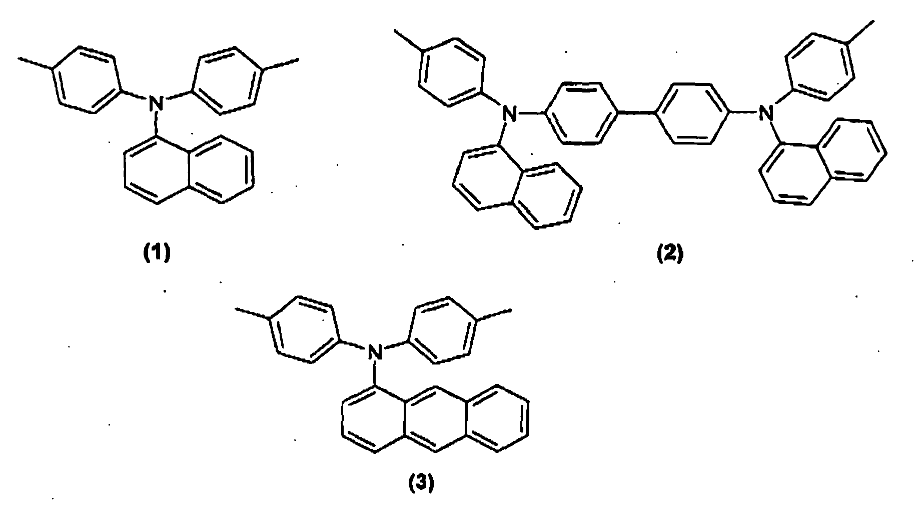 ausgenommen sind, wenn das konjugierte Polymer Metallkomplexe enthält, welche einen Transfer von Singulett-Excitonen zu Triptett-Excitonen ermöglichen.

2. Polymere gemäß Anspruch 1, **dadurch gekennzeichnet, dass** es sich um konjugierte Polymere handelt.

3. Polymere gemäß Anspruch 1 und/oder 2, **dadurch gekennzeichnet, dass** der Diederwinkel zwischen den mindestens zwei Arylengruppen der Einheit X kleiner als 30° ist.

4. Polymere gemäß einem oder mehreren der Ansprüche 1 bis 3, **dadurch gekennzeichnet, dass** es sich bei der Einheit X um ein steifes planares konjugiertes System handelt, das nicht durch Rotation um eine Einfachbindung von der Planarität abweichen kann.

5. Polymere gemäß einem oder mehreren der Ansprüche 1 bis 4, **dadurch gekennzeichnet, dass** die Verknüpfung der Einheiten gemäß Formel (1) in das Polymer über die Einheiten Ar¹ bis Ar⁵ so erfolgt, dass eine gerade Anzahl C-Atome bzw. entsprechend O, N und/oder S zwischen der Verknüpfung mit dem Polymer und dem Stickstoffatom liegt.

6. Polymere gemäß einem oder mehreren der Ansprüche 1 bis 5, **dadurch gekennzeichnet, dass** die Einheiten gemäß Formel (1) in die Hauptkette des Polymers gebunden sind.

7. Polymere gemäß Anspruch 6, **dadurch gekennzeichnet, dass** die Einheiten gemäß Formel (1) über die Gruppen Ar¹ und Ar³ an das Polymer gebunden sind.

8. Polymere gemäß einem oder mehreren der Ansprüche 1 bis 7, **dadurch gekennzeichnet, dass** weitere Struktureinheiten ausgewählt sind aus Einheiten, welche das Polymer-Grundgerüst bilden, welche die Morphologie bzw. die Emissionsfarbe verändern, welche die Lochinjektions- und/oder die Lochtransporteigenschaften erhöhen, welche die Elektroneninjektions- und/oder die Elektronentransporteigenschaften erhöhen, welche Kombinationen der beiden letztgenannten Einheiten aufweisen, welche aus dem Tripiett-Zustand Licht emittieren und/oder welche den Transfer vom Singulett- zum Triplett-Zustand verbessern.

9. Polymere gemäß Anspruch 8, **dadurch gekennzeichnet, dass** diese mindestens 50 mol% Einheiten, die das Polymer-Grundgerost bilden, enthalten.

10. Polymere gemäß einem oder mehreren der Ansprüche 1 bis 9, **dadurch gekennzeichnet, dass** der Anteil Einheiten gemäß Formel (1) 1 - 50 mol% beträgt.

11. Polymere gemäß Anspruch 10, **dadurch gekennzeichnet, dass** der Anteil Einheiten gemäß Formel (1) 5 - 30 mol% beträgt.

12. Polymere gemäß einem oder mehreren der Ansprüche 1 bis 11, **dadurch gekennzeichnet, dass** das Symbol X, gleich oder verschieden bei jedem Auftreten, für eine Gruppe gemäß Formel (3) steht:

13. Polymere gemäß einem oder mehreren der Ansprüche 1 bis 12, **dadurch gekennzeichnet, dass** die Symbole Ar¹ bis Ar⁵, gleich oder verschieden bei jedem Auftreten, für ein aromatisches Ringsystem mit 6 bis 30 C-Atomen stehen, das mit R¹ substituiert sein kann, oder für ein heteroaromatisches Ringsystem mit 4 bis 30 C-Atomen stehen, das mit R¹ substituiert sein kann.

14. Polymere gemäß einem oder mehreren der Ansprüche 1 bis 13, **dadurch gekennzeichnet, dass** der Index n, gleich oder verschieden bei jedem Auftreten, für 0 oder 1 steht.

15. Polymere gemäß einem oder mehreren der Ansprüche 1 bis 14, **dadurch gekennzeichnet, dass** die Einheiten gemäß Formel (1) asymmetrisch aufgebaut sind. 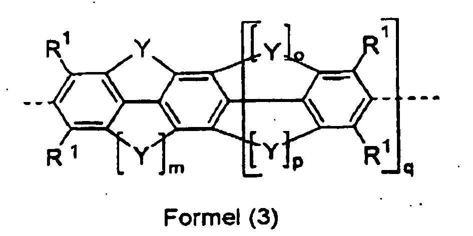 wobei für die verwendeten Symbole und Indizes gilt:
Y ist bei jedem Auftreten gleich oder verschieden -C(R¹)₂-, -C(R¹)₂-C(R¹)₂-, -N(R¹)-, -O-, -S-, -P(R¹)-, -P(=O)(R¹)-, -O-C(R¹)₂- oder -O-C(=O)-:
m ist bei jedem Auftreten gleich oder verschieden 0 oder 1, wobei im Fall, dass der Index m = 0 ist, der Rest Y entfällt und keiner chemischen Bindung entspricht;
o, p sind bei jedem Auftreten gleich oder verschieden 0 oder 1, mit der Maßgabe, dass o und p nicht gleichzeitig 0 sein dürfen, wobei im Fall, dass einer der Indizes o oder p = 0 ist, der Rest Y entfällt und keiner chemischen Bindung entspricht;
q ist bei jedem Auftreten gleich oder verschieden 0, 1 oder 2;
dabei stellt die gestrichelte Bindung in Formel (3) die Verknüpfung dieser Struktureinheit mit dem Atom N in Struktureinheiten gemäß Formel (1) dar.

16. Polymere gemäß einem oder mehreren der Ansprüche 1 bis 15, **dadurch gekennzeichnet, dass** die Einheiten gemäß Formel (1) aus den Beispielstrukturen (1) bis (27), die mit R¹ substituiert sein können, ausgewählt sind.

17. Polymere gemäß einem oder mehreren der Ansprüche 1 bis 16, **dadurch gekennzeichnet, dass** sie durch Polymerisation gemäß SUZUKI, gemäß YAMAMOTO, gemäß STILLE oder gemäß HARTWIG-BUCHWALD hergestellt werden.

18. Blends aus einem oder mehreren Polymeren gemäß einem oder mehreren der Ansprüche 1 bis 17 mit weiteren polymeren, oligomeren, dendritischen oder niedermolekularen Verbindungen.

19. Lösungen und Formulierungen aus einem oder mehreren Polymeren oder Blends gemäß einem oder mehreren der Ansprüche 1 bis 18 in einem oder mehreren Lösungsmitteln.

20. Verwendung eines Polymers und/oder eines Blends und/oder einer Lösung gemäß einem oder mehreren der Anspruche 1 bis 19 in elektronischen Bauteilen.

21. Elektronisches Bauteil, enthaltend eine oder mehrere Schichten, **dadurch gekennzeichnet, dass** mindestens eine dieser Schichten mindestens ein Polymer oder Blend gemäß einem oder mehreren der Ansprüche 1 bis 18 enthält.

22. Elektronisches Bauteil gemäß Anspruch 21, **dadurch gekennzeichnet, dass** es sich um eine polymere organische Leuchtdiode (PLED), einen organischen Feld-Effekt-Transistor (O-FET), eine organische integrierte Schaltung (O-IC), einen organischen Dünnfilmtransistor (O-TFT), eine organische Solarzelle (O-SC), ein organisches Field-Ouench-Device (O-FQD) oder eine organische Laserdiode (O-Laser) handelt.

## Claims

1. Conjugated or partially conjugated polymers containing at least 0.1 mol% of units of the formula (1) 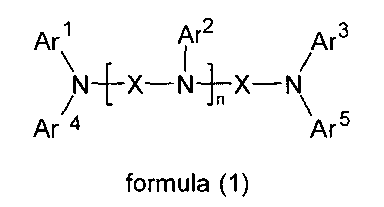 where the symbols and indices used have the following meaning:
X is on each occurrence, identically or differently, a divalent planar conjugated system having 6 to 40 C atoms, which contains at least two arylene groups and which may be substituted by R¹;
Ar¹, Ar², Ar³, Ar⁴, Ar⁵ are on each occurrence, identically or differently, an aromatic ring system having 6 to 40 C atoms, which may be substituted by one or more radicals R¹, or a heteroaromatic ring system having 2 to 40 C atoms, which may be substituted by one or more radicals R¹, with the proviso that none of the groups Ar¹ to Ar⁵ represents a condensed ring system if this group does not have a direct bond to the polymer chain;
R¹ is on each occurrence, identically or differently, H, F, Cl, Br, I, CN, NO₂, OH, N(R¹)₂, Si(R²)₃, B(R²)₂, a straight-chain, branched or cyclic alkyl, alkoxy or thioalkoxy group having 1 to 40 C atoms, in which, in addition, one or more non-adjacent C atoms may be replaced by -CR²=CR²-, -C≡C-, -NR²-, -O-, -S-, -CO-O- or -O-CO-O-, where, in addition, one or more H atoms may be replaced by fluorine, an aryl, heteroaryl, aryloxy or heteroaryloxy group having 2 to 40 C atoms, in which, in addition, one or more C atoms may be replaced by O, S or N and which, in addition, may be substituted by one or more non-aromatic radicals R¹; two or more of the radicals R¹ here may also form an aliphatic or aromatic, mono- or polycyclic ring system with one another;
R² is on each occurrence, identically or differently, H or an aliphatic or aromatic hydrocarbon radical having 1 to 20 C atoms;
n is on each occurrence, identically or differently, 0, 1 or 2;
the linking of the units of the formula (1) to the polymer takes place via one or two of the groups Ar¹ to Ar⁵;
with the exception of polymers of the formula (2) 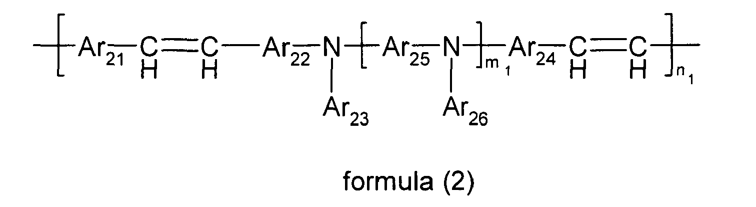 in which: Ar₂₁, Ar₂₂, Ar₂₄ are each an arylene group, which may carry a substituent; Ar₂₅ is an arylene group or a divalent polycondensed ring group, which may carry a substituent; Ar₂₃ and Ar₂₆ are each an alkyl group, an aralkyl group or an aryl group, which may carry a substituent; m₁ is 0, 1, 2 or 3; n₁ is a natural number;
with the further exception of conjugated polymers containing at least 1 mol% of units of the formula (I) 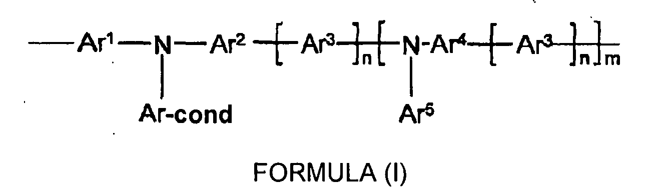 where the symbols and indices have the following meaning:
Ar¹, Ar³ are on each occurrence, identically or differently, an aromatic or heteroaromatic ring system having 2 to 40 C atoms, which may be substituted or also unsubstituted; the possible substituents R1 here may potentially sit in any free position;
Ar², Ar⁴ are on each occurrence, identically or differently, Ar¹, Ar³ or a substituted or unsubstituted stilbenylene or tolanylene unit;
Ar-cond is on each occurrence, identically or differently, an aromatic or heteroaromatic ring system which has at least 9, but at most 40 atoms (C or heteroatoms) in the conjugated system, which may be substituted or also unsubstituted and which consists of at least two condensed rings; the possible substituents R1 here may potentially sit in any free position;
Ar⁵ is, identically or differently on each occurrence, either an aromatic or heteroaromatic ring system having 2 to 40 C atoms, which may be substituted or also unsubstituted, or Ar-cond; the possible substituents R1 here may potentially sit in any free position;
m, n are, identically or differently on each occurrence, 0, 1 or 2;
R1 is on each occurrence, identically or differently, a straight-chain, branched or cyclic alkyl or alkoxy chain having 1 to 22 C atoms, in which, in addition, one or more non-adjacent C atoms may be replaced by N-R2, O, S, -CO-O-, O-CO-O, where, in addition, one or more H atoms may be replaced by fluorine, an aryl or aryloxy group having 5 to 40 C atoms, in which, in addition, one or more C atoms may be replaced by O, S or N, which, in addition, may be substituted by one or more non-aromatic radicals R1, or Cl, F, CN, N(R2)₂, B(R2)₂, where, in addition, two or more radicals R1 may form a ring system with one another;
R2 is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O, where, in addition, one or more H atoms may be replaced by fluorine, an aryl group having 5 to 40 C atoms, in which, in addition, one or more C atoms may be replaced by O, S or N, which, in addition, may be substituted by one or more non-aromatic radicals R1;
with the proviso that the units of structures (1) to (3) 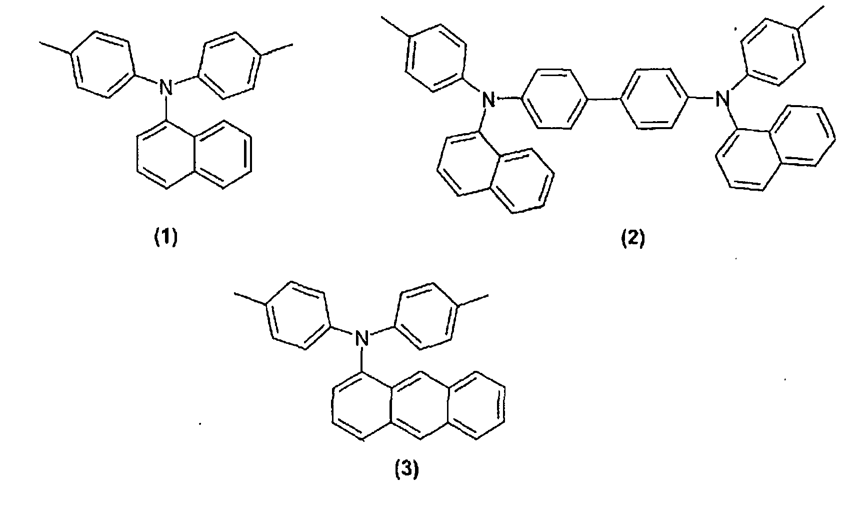 are excluded if the conjugated polymer contains metal complexes which facilitate transfer of singlet excitons to triplet excitons.

2. Polymers according to Claim 1, **characterised in that** they are conjugated polymers.

3. Polymers according to Claim 1 and/or 2, **characterised in that** the dihedral angle between the at least two arylene groups of unit X is less than 30°.

4. Polymers according to one or more of Claims 1 to 3, **characterised in that** the unit X is a rigid planar conjugated system which cannot deviate from planarity by rotation about a single bond.

5. Polymers according to one or more of Claims 1 to 4, **characterised in that** the linking of the units of the formula (1) into the polymer takes place via units Ar¹ to Ar⁵ in such a way that an even number of C atoms or correspondingly O, N and/or S lies between the link to the polymer and the nitrogen atom.

6. Polymers according to one or more of Claims 1 to 5, **characterised in that** the units of the formula (1) are bonded into the main chain of the polymer.

7. Polymers according to Claim 6, **characterised in that** the units of the formula (1) are bonded to the polymer via groups Ar¹ and Ar³.

8. Polymers according to one or more of Claims 1 to 7, **characterised in that** further structural units are selected from units which form the polymer backbone, which modify the morphology or emission colour, which enhance the hole-injection and/or hole-transport properties, which enhance the electron-injection and/or electron-transport properties, which have combinations of the two last-mentioned units, which emit light from the triplet state and/or which improve the transfer from the singlet state to the triplet state.

9. Polymers according to Claim 8, **characterised in that** they contain at least 50 mol% of units which form the polymer backbone.

10. Polymers according to one or more of Claims 1 to 9, **characterised in that** the proportion of units of the formula (1) is 1 - 50 mol%.

11. Polymers according to Claim 10, **characterised in that** the proportion of units of the formula (1) is 5 - 30 mol%.

12. Polymers according to one or more of Claims 1 to 11, **characterised in that** the symbol X, identically or differently on each occurrence, stands for a group of the formula (3): 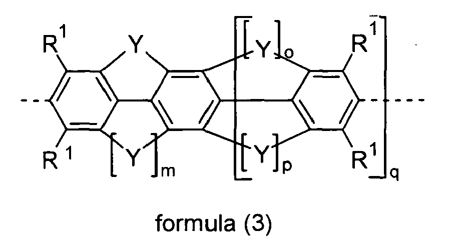 where the following applies to the symbols and indices used:
Y is on each occurrence, identically or differently, -C(R¹)₂-, -C(R¹)₂-C(R¹)₂-, -N(R¹)-, -O-, -S-, -P(R¹)-, -P(=O)(R¹)-, -O-C(R¹)₂- or -O-C(=O)-;
m is on each occurrence, identically or differently, 0 or 1, where in the case where the index m = 0, the radical Y is omitted and does not correspond to a chemical bond;
o, p are on each occurrence, identically or differently, 0 or 1, with the proviso that o and p cannot simultaneously be 0, where in the case where one of the indices o or p = 0, the radical Y is omitted and does not correspond to a chemical bond;
q is on each occurrence, identically or differently, 0, 1 or 2;
the dashed bond in formula (3) represents the link from this structural unit to the atom N in structural units of the formula (1).

13. Polymers according to one or more of Claims 1 to 12, **characterised in that** the symbols Ar¹ to Ar⁵, identically or differently on each occurrence, stand for an aromatic ring system having 6 to 30 C atoms, which may be substituted by R¹, or for a heteroaromatic ring system having 4 to 30 C atoms, which may be substituted by R¹.

14. Polymers according to one or more of Claims 1 to 13, **characterised in that** the index n, identically or differently on each occurrence, stands for 0 or 1.

15. Polymers according to one or more of Claims 1 to 14, **characterised in that** the units of the formula (1) have a symmetrical structure.

16. Polymers according to one or more of Claims 1 to 15, **characterised in that** the units of the formula (1) are selected from example structures (1) to (27), which may be substituted by R¹.

17. Polymers according to one or more of Claims 1 to 16, **characterised in that** they are prepared by SUZUKI, YAMAMOTO, STILLE or HARTWIG-BUCHWALD polymerisation.

18. Blends of one or more polymers according to one or more of Claims 1 to 17 with further polymeric, oligomeric, dendritic or low-molecular-weight compounds.

19. Solutions and formulations of one or more polymers or blends according to one or more of Claims 1 to 18 in one or more solvents.

20. Use of a polymer and/or a blend and/or a solution according to one or more of Claims 1 to 19 in electronic components.

21. Electronic component comprising one or more layers, **characterised in that** at least one of these layers comprises at least one polymer or blend according to one or more of Claims 1 to 18.

22. Electronic component according to Claim 21, **characterised in that** it is a polymeric organic light-emitting diode (PLED), an organic field-effect transistor (O-FET), an organic integrated circuit (O-IC), an organic thin-film transistor (O-TFT), an organic solar cell (O-SC), an organic field-quench device (O-FQD) or an organic laser diode (O-laser).

## Revendications

1. Polymères conjugués ou partiellement conjugués contenant au moins 0,1 %molaire d'unités de la formule (1) 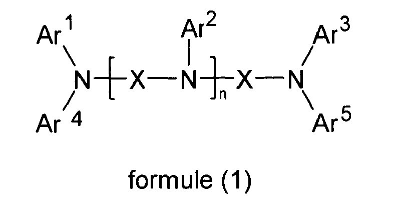 dans laquelle les symboles et indices utilisés ont la signification qui suit :
X est à chaque occurrence, de façon identique ou différente, un système conjugué plan divalent ayant 6 à 40 atomes de C, qui contient au moins deux groupes arylène et qui peut être substitué par R¹;
Ar¹, Ar², Ar³, Ar⁴, Ar⁵ sont à chaque occurrence, de façon identique ou différente, un système de cycle aromatique ayant 6 à 40 atomes de C, qui peut être substitué par un ou plusieurs radicaux R¹, ou un système de cycle hétéroaromatique ayant 2 à 40 atomes de C, qui peut être substitué par un ou plusieurs radicaux R¹, étant entendu qu'aucun des groupes Ar¹ à Ar⁵ ne représente un système de cycle condensé si ce groupe n'a pas une liaison directe à la chaîne polymère ;
R¹ est à chaque occurrence, de façon identique ou différente, H, F, CI, Br, I, CN, NO₂, OH, N(R¹)₂, Si(R²)₃, B(R²)₂, un groupe alkyle, alcoxy ou thioalcoxy en chaîne droite, ramifié ou cyclique ayant 1 à 40 atomes de C, dans lequel, en addition, un ou plusieurs atomes de C non adjacents peuvent être remplacés par -CR²=_{CR}²-, -C≡C-, -NR²-, -O-, -S-, -CO-O- ou -O-CO-O-, où, en addition, un ou plusieurs atomes de H peuvent être remplacés par fluor, un groupe aryle, hétéroaryle, aryloxy ou hétéroaryloxy ayant 2 à 40 atomes de C, dans lequel, en addition, un ou plusieurs atomes de C peuvent être remplacés par O, S ou N et qui, en addition, peut être substitué par un ou plusieurs radicaux R¹ non aromatiques ; deux ou plus de deux des radicaux R¹ ici peuvent également former un système de cycle mono- ou polycyclique aliphatique ou aromatique avec un autre ;
R² est à chaque occurrence, de façon identique ou différente, H ou un radical hydrocarbure aliphatique ou aromatique ayant 1 à 20 atomes de C ;
n est à chaque occurrence, de façon identique ou différente, 0, 1 ou 2;
le liage des unités de la formule (1) au polymère s'effectue via un ou deux des groupes Ar¹ à Ar⁵ ;
à l'exception des polymères de la formule (2) 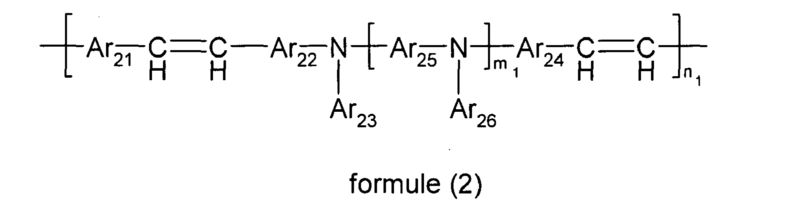 dans laquelle : Ar₂₁, Ar₂₂, Ar₂₄ sont chacun un groupe arylène, qui peut porter un substituant ; Ar₂₅ est un groupe arylène ou un groupe de cycle polycondensé divalent, qui peut porter un substituant ; Ar₂₃ et Ar₂₆ sont chacun un groupe alkyle, un groupe aralkyle ou un groupe aryle, qui peut porter un substituant ; m₁ est 0, 1, 2 ou 3 ; n₁ est un nombre naturel ;
à l'exception supplémentaire des polymères conjugués contenant au moins 1 %molaire d'unités de la formule (I) 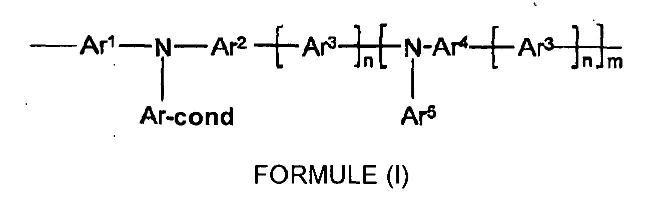 dans laquelle les symboles et indices ont la signification qui suit :
Ar¹, Ar³ sont à chaque occurrence, de façon identique ou différente, un système de cycle aromatique ou hétéroaromatique ayant 2 à 40 atomes de C, qui peut être substitué ou également non substitué ; les substituants possibles R1 peuvent ici potentiellement résider dans n'importe quelle position libre ;
Ar², Ar⁴ sont à chaque occurrence, de façon identique ou différente, Ar¹, Ar³ ou une unité stilbénylène ou tolanylène substituée ou non substituée ;
Ar-cond est à chaque occurrence, de façon identique ou différente, un système de cycle aromatique ou hétéroaromatique qui a au moins 9, mais au plus 40 atomes (C ou hétéroatomes) dans le système conjugué, qui peut être substitué ou également non substitué et qui consiste en au moins deux cycles condensés ; les substituants possibles R1 ici peuvent potentiellement résider dans n'importe quelle position libre ;
Ar⁵ est, de façon identique ou différente à chaque occurrence, soit un système de cycle aromatique ou hétéroaromatique ayant 2 à 40 atomes de C, qui peut être substitué ou également non substitué, soit Ar-cond ; les substituants possibles R1 ici peuvent potentiellement résider dans n'importe quelle position libre ;
m, n sont, de façon identique ou différente à chaque occurrence, 0, 1 ou 2 ;
R1 est à chaque occurrence, de façon identique ou différente, une chaîne alkyle ou alcoxy en chaîne droite, ramifiée ou cyclique ayant 1 à 22 atomes de C, dans laquelle, en addition, un ou plusieurs atomes de C non adjacents peuvent être remplacés par N-R2, O, S, -CO-O-, O-CO-O, où, en addition, un ou plusieurs atomes de H peuvent être remplacés par fluor, un groupe aryle ou aryloxy ayant 5 à 40 atomes de C, dans lequel, en addition, un ou plusieurs atomes de C peuvent être remplacés par O, S ou N, qui, en addition, peut être substitué par un ou plusieurs radicaux R1 non aromatiques, ou CI, F, CN, N(R2)₂, B(R2)₂, où, en addition, deux ou plus de deux radicaux R1 peuvent former un système de cycle avec un autre ;
R2 est à chaque occurrence, de façon identique ou différente, H, une chaîne alkyle en chaîne droite, ramifiée ou cyclique ayant 1 à 22 atomes de C, dans laquelle, en addition, un ou plusieurs atomes de C non adjacents peuvent être remplacés par O, S, -CO-O-, O-CO-O, où, en addition, un ou plusieurs atomes de H peuvent être remplacés par fluor, un groupe aryle ayant 5 à 40 atomes de C, dans lequel, en addition, un ou plusieurs atomes de C peuvent être remplacés par O, S ou N, qui, en addition, peut être substitué par un ou plusieurs radicaux R1 non aromatiques ;
étant entendu que les unités des structures (1) à (3) 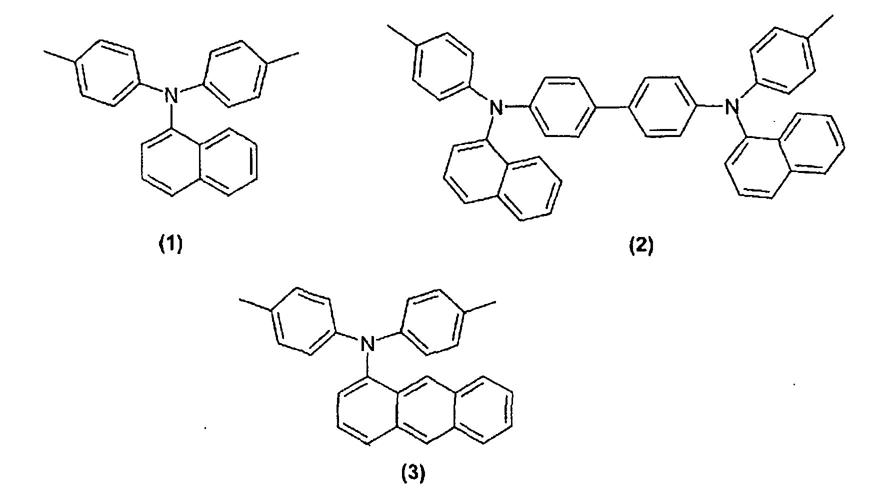 sont exclues si le polymère conjugué contient des complexes métalliques qui facilitent le transfert d'excitons singlet vers excitons triplet.

2. Polymères selon la revendication 1, **caractérisés en ce qu'**ils sont des polymères conjugués.

3. Polymères selon la revendication 1 et/ou 2, **caractérisés en ce que** l'angle dihédral entre les au moins deux groupes arylène d'unité X est inférieur à 30°.

4. Polymères selon une ou plusieurs des revendications 1 à 3, **caractérisés en ce que** l'unité X est un système conjugué plan rigide qui ne peut pas dévier de la planéité par rotation autour d'une liaison simple.

5. Polymères selon une ou plusieurs des revendications 1 à 4, **caractérisés en ce que** le liage des unités de la formule (1) selon le polymère s'instaure via les unités Ar¹ à Ar⁵ de telle sorte qu'un nombre pair d'atomes de C ou de façon correspondante O, N et/ou S s'étendent entre la liaison au polymère et l'atome d'azote.

6. Polymères selon une ou plusieurs des revendications 1 à 5, **caractérisés en ce que** les unités de la formule (1) sont liées selon la chaîne principale du polymère.

7. Polymères selon la revendication 6, **caractérisés en ce que** les unités de la formule (1) sont liées au polymère via les groupes Ar¹ et Ar³.

8. Polymères selon une ou plusieurs des revendications 1 à 7, **caractérisés en ce que** des unités structurelles supplémentaires sont choisies parmi des unités qui forment le squelette de polymère, lesquelles modifient la morphologie ou l'émission de couleur, lesquelles améliorent les propriétés d'injection de trous et/ou de transport de trous, lesquelles améliorent les propriétés d'injection d'électrons et/ou de transport d'électrons, lesquelles ont des combinaisons des deux unités mentionnées en dernier, lesquelles émettent une lumière depuis l'état triplet et/ou augmentent le transfert depuis l'état singlet jusqu'à l'état triplet.

9. Polymères selon la revendication 8, **caractérisés en ce qu'**ils contiennent au moins 50 %molaire d'unités qui forment le squelette de polymère.

10. Polymères selon une ou plusieurs des revendications 1 à 9, **caractérisés en ce que** la proportion d'unités de la formule (1) est 1 - 50 %molaire.

11. Polymères selon la revendication 10, **caractérisés en ce que** la proportion d'unités de la formule (1) est 5 - 30 %molaire.

12. Polymères selon une ou plusieurs des revendications 1 à 11, **caractérisés en ce que** le symbole X, de façon identique ou différente à chaque occurrence, représente un groupe de la formule (3): 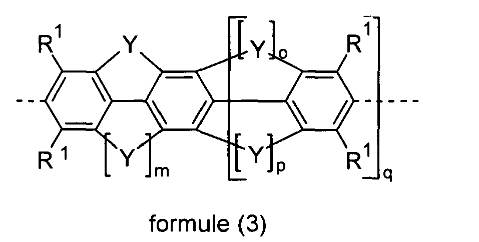 dans laquelle ce qui suit s'applique aux symboles et indices utilisés :
Y est à chaque occurrence, de façon identique ou différente, -C(R¹)₂-, -C(R¹)₂-C(R¹)₂-, -N(R¹)-, -O-, -S-, -P(R¹)-, -P(=O)(R¹)-, -O-C(R¹)₂- ou -O-C(=O)- ;
m est à chaque occurrence, de façon identique ou différente, 0 ou 1, où dans le cas où l'indice m = 0, le radical Y est omis et ne correspond pas à une liaison chimique ;
o, p sont à chaque occurrence, de façon identique ou différente, 0 ou 1, étant entendu que o et p ne peuvent pas simultanément être 0, où dans le cas où les indices o ou p = 0, le radical Y est omis et ne correspond pas à une liaison chimique ;
q est à chaque occurrence, de façon identique ou différente, 0, 1 ou 2;
la liaison en pointillés dans la formule (3) représente la liaison depuis cette unité structurelle jusqu'à l'atome N dans les unités structurelles de la formule (1).

13. Polymères selon une ou plusieurs des revendications 1 à 12, **caractérisés en ce que** les symboles Ar¹ à Ar⁵, de façon identique ou différente à chaque occurrence, représentent un système de cycle aromatique ayant 6 à 30 atomes de C, qui peut être substitué par R¹, ou un système de cycle hétéroaromatique ayant 4 à 30 atomes de C, qui peut être substitué par R¹.

14. Polymères selon une ou plusieurs des revendications 1 à 13, **caractérisés en ce que** les indices n, de façon identique ou différente à chaque occurrence, représentent 0 ou 1.

15. Polymères selon une ou plusieurs des revendications 1 à 14, **caractérisés en ce que** les unités de la formule (1) ont une structure symétrique.

16. Polymères selon une ou plusieurs des revendications 1 à 15, **caractérisés en ce que** les unités de la formule (1) sont choisies parmi les structures d'exemple (1) à (27), qui peuvent être substituées par R¹.

17. Polymères selon une ou plusieurs des revendications 1 à 16, **caractérisés en ce qu'**ils sont préparés par polymérisation de SUZUKI, YAMAMOTO, STILLE ou HARTWIG-BUCHWALD.

18. Mélanges d'un ou plusieurs polymères selon une ou plusieurs des revendications 1 à 17 avec des composés supplémentaires polymériques, oligomériques, dendritiques ou à faible poids moléculaire.

19. Solutions et formulations d'un ou plusieurs polymères ou mélanges selon une ou plusieurs des revendications 1 à 18 dans un ou plusieurs solvants.

20. Utilisation d'un polymère et/ou d'un mélange et/ou d'une solution selon une ou plusieurs des revendications 1 à 19 dans des composants électroniques.

21. Composant électronique comprenant une ou plusieurs couches, **caractérisé en ce qu'**au moins une de ces couches comprend au moins un polymère ou mélange selon une ou plusieurs des revendications 1 à 18.

22. Composant électronique selon la revendication 21, **caractérisé en ce qu'**il est une diode émettrice de lumière organique polymérique (PLED), un transistor à effet de champ organique (O-FET), un circuit intégré organique (O-IC), un transistor à film mince organique (O-TFT), une cellule solaire organique (O-SC), un dispositif à extinction de champ organique (O-FQD) ou un diode laser organique (O-laser).
